Europäisches Patentamt

**European Patent Office**

**Office européen des brevets**

(11) Numéro de publication : **0 142 415 B1**

# FASCICULE DE BREVET EUROPÉEN

(45) Date de publication du fascicule du brevet :
27.07.88

(51) Int. Cl.⁴ : **C 30 B 15/28, C 30 B 15/22**

(21) Numéro de dépôt : **84402087.5**

(22) Date de dépôt : **17.10.84**

(54) **Procédé de commande d'une machine de tirage de monocristaux.**

(30) Priorité : **19.10.83 FR 8316634**

(43) Date de publication de la demande :
**22.05.85 Bulletin 85/21**

(45) Mention de la délivrance du brevet :
**27.07.88 Bulletin 88/30**

(84) Etats contractants désignés :
**DE GB NL**

(56) Documents cités :
**EP-A- 0 056 572**
**FR-A- 2 071 788**

(73) Titulaire : **COMMISSARIAT A L'ENERGIE ATOMIQUE**
**31/33, rue de la Fédération**
**F-75015 Paris (FR)**

(72) Inventeur : **Lissalde, François**
**6 rue des Bleuets**
**F-38170 Seyssins (FR)**
Inventeur : **Delageniere, Bruno**
**5, rue Billerey**
**F-38000 Grenoble (FR)**
Inventeur : **Ferrieu, Bruno**
**81, rue de Cartale**
**F-38170 Seyssinet (FR)**

(74) Mandataire : **Mongrédien, André et al**
**c/o BREVATOME 25, rue de Ponthieu**
**F-75008 Paris (FR)**

EP 0 142 415 B1

**0 142 415**

## Description

La présente invention concerne un procédé de commande d'une machine de tirage de monocristaux.

Ce procédé permet de tirer des monocristaux à partir d'un bain de produits fondus ; ces monocristaux sont essentiellement utilisés pour la fabrication de circuits intégrés. Ce procédé est mis en œuvre par une machine de tirage dans laquelle le bain de produit fondu est contenu dans un creuset et est maintenu à une température supérieure au point de fusion du produit, par des moyens de chauffage appropriés. Le cristal massif ou lingot est obtenu par croissance d'un germe monocristallin du même produit, placé à l'extrémité inférieure d'une broche de tirage d'axe vertical, selon une méthode dite de Czochralski, connue dans l'état de la technique et qui ne sera pas décrite ici en détail.

Les machines de tirage fonctionnant selon la méthode de Czochralski sont principalement utilisées dans la cristallisation de matériaux pour lesquels à l'état solide cristallisé, ces matériaux présentent la même composition qu'à l'état liquide. On dit alors que ces matériaux présentent une fusion congruente. C'est le cas, par exemple, de certains oxydes ainsi que des semiconducteurs du type silicium ou germanium.

Dans les machines connues qui permettent d'effectuer des tirages de monocristaux selon la méthode de Czochralsky, le germe monocristallin est amené au contact du bain liquide, dont la température est ajustée de façon qu'à l'interface solide-liquide, existent des conditions telles qu'à chaque instant, la quantité d'atomes cristallisés soit identique à la quantité d'atomes qui retournent en fusion. La croissance est obtenue en exerçant sur une broche de tirage, dont une extrémité permet de fixer le germe, un mouvement régulier de translation vertical à une vitesse généralement comprise entre 1 et 30 mm par heure. Pour contrôler la forme de l'interface solide-liquide, on superpose au mouvement de translation de la broche, un mouvement de rotation de celle-ci autour de son axe à une vitesse généralement comprise entre 0 et 100 tours par minute. Le déplacement vers le haut de l'interface solide-liquide amène cet interface dans une zone plus froide, ce qui a pour effet de faire cristalliser le bain sur le germe, et ainsi de faire croître le monocristal dans le but d'en former un lingot cylindrique de diamètre aussi constant que possible.

La nécessité d'obtenir des monocristaux de géométrie régulière a conduit les réalisateurs de machines à rechercher des procédés de commande aboutissant à la régularité du diamètre du monocristal au cours de son tirage. Cette régularité est généralement obtenue à partir des mesures du poids du monocristal en cours de tirage. A cet effet, un capteur de poids est généralement placé à une extrémité de la broche de tirage et transmet des signaux représentatifs des valeurs de poids à un ensemble de traitement et de commande ; ces moyens de traitement et de commande permettent de contrôler la translation et la rotation de la broche. Les machines connues ne sont pas entièrement automatiques, car les procédés qu'elles mettent en œuvre n'utilisent pas des traitements adéquats des informations de poids au cours du tirage et des informations concernant la géométrie du cristal à obtenir.

Il en résulte que la régulation des moyens de chauffage contenant le creuset, l'approche rapide puis lente de la surface du produit en fusion contenu dans le creuset, le contact du germe avec la surface du produit en fusion, le tirage du monocristal après que ce contact ait été effectué, puis le refroidissement du four à la fin du tirage, sont des opérations qui ne sont pas entièrement automatiques qui sont effectuées de manière souvent empirique et dont les résultats sont par conséquent aléatoires, ce qui est un grave inconvénient car les monocristaux à obtenir sont des produits très coûteux. Ce type de machine est décrit, par exemple, dans le brevet EP-A-56 572.

La présente invention a pour but de remédier à ces inconvénients grâce à un procédé de commande d'une machine de tirage de monocristaux rendant celle-ci entièrement automatique et se particularisant par les mesures indiquées dans la partie caractérisante de la revendication 1.

L'invention a pour objet un procédé de commande d'une machine de tirage de monocristaux comprenant un creuset contenant un bain d'un produit fondu et stabilisé à une température supérieure au point de fusion du produit, par des moyens de chauffage de régulation et de mesure de température, le tirage étant effectué à l'aide d'un germe monocristallin du produit placé à l'extrémité inférieure d'une broche de tirage d'axe vertical, la machine comprenant aussi un bâti fixe, un chariot mobile par rapport au bâti parallèlement à l'axe propre de la broche de tirage, des moyens pour commander la translation du chariot selon au moins deux vitesses différentes, des moyens pour commander une translation du creuset parallèlement à l'axe de la broche, le chariot supportant la broche de tirage par l'intermédiaire de moyens pour commander la rotation de celle-ci autour de son axe propre, la broche de tirage comprenant un capteur de poids fournissant des signaux représentatifs du poids de la broche et du germe, avant le tirage, et de l'évolution de ce poids au cours du tirage, ces signaux étant appliqués à des circuits de traitement électronique reliés à un calculateur de contrôle de la régulation des moyens de chauffage et de contrôle des moyens de commande de translation du chariot, de translation du creuset et de rotation de la broche, le procédé consistant aussi à enregistrer dans une mémoire du calculateur, des paramètres prédéterminés relatifs à la géométrie du monocristal à obtenir et à la croissance de celui-ci, des signaux représentatifs du poids fournis par le capteur de poids et traités par les circuits de traitement, et à enregistrer dans cette mémoire un programme pour que ce calculateur commande une mise à la température des moyens de chauffage pour produire la fusion du produit, puis après contact du germe

2

avec la surface du bain, une régulation automatique de la température des moyens de chauffage pour une croissance nulle du cristal, le tirage automatique du cristal et le refroidissement des moyens de chauffage à la fin du tirage, caractérisé en ce que le programme enregistré dans la mémoire est en outre conçu pour commander une approche automatique rapide du bain par la broche munie du germe, jusqu'à une distance prédéterminée de la surface de ce bain, une approche plus lente du bain jusqu'au contact du germe avec la surface du bain, les approches lente et rapide et le tirage étant effectués par l'action du calculateur sur les moyens de commande de la translation du chariot et du creuset et de rotation de la broche, à partir des mesures du poids du germe et du cristal fournies par le capteur de poids, la régulation automatique des moyens de chauffage pour une croissance nulle du monocristal intervenant dès le contact du germe avec la surface du bain et consistant à déterminer à partir des signaux fournis par le capteur, les dérivées de poids par rapport au temps, pour une période d'échantillonnage prédéterminée, puis à appliquer à la fonction représentative de l'écart de ces dérivées de poids par rapport à une référence nulle de dérivée de poids, une action proportionnelle et intégrale avec un écrêtage différent, selon que ces écarts sont appliqués au terme proportionnel ou au terme intégral, la fonction ainsi traitée étant représentative d'une tension de consigne des moyens de chauffage pour une croissance nulle du monocristal, les amplitudes des signaux fournis par le capteur étant situées entre les deux limites prédéterminées pendant cette opération de régulation.

Selon une autre caractéristique, la détection du contact du germe avec la surface du bain consiste à repérer une singularité dans les signaux représentatifs du poids de la broche et du germe au moment du contact du germe avec la surface des produits en fusion, les amplitudes de ces signaux et de cette singularité étant situées entre deux limites haute et basse prédéterminées.

Selon une autre caractéristique, le tirage consiste par translation de la broche et du creuset à maintenir une variation contrôlée des dérivées de poids au cours du tirage, par comparaison de ces dérivées avec une dérivée de poids de référence, la régulation de la température des moyens de chauffage étant obtenue à partir de la fonction représentative de l'écart de ces dérivées de poids, traitée par une action proportionnelle et intégrale avec un écrêtage différent selon que ces écarts sont appliqués au terme proportionnel ou au terme intégral, la fonction ainsi traitée étant représentative d'une tension de régulation des moyens de chauffage pour une croissance contrôlée du monocristal.

Selon une autre caractéristique, le procédé consiste à abaisser la température des moyens de chauffage lorsque les amplitudes des signaux fournis par le capteur sont inférieures à la limite la plus basse, et à augmenter cette température lorsque les amplitudes des signaux fournis par le capteur sont supérieures à la limite la plus haute.

Selon une autre caractéristique, le procédé consiste en outre à interrompre les commandes du calculateur en cas d'incident, ou pour introduire dans la mémoire des nouveaux paramètres de régulation ou de tirage.

Selon une autre caractéristique, le procédé consiste à utiliser comme signal pertinent de régulation, la dérivée de poids du cristal dont on cherche à contrôler la croissance.

Selon une autre caractéristique, le procédé consiste à filtrer numériquement le rapport signal/bruit de la dérivée de poids.

Selon une autre caractéristique, la dérivée de poids est prise sur un nombre M entier de périodes d'échantillonnage, le filtrage consistant à effectuer une moyenne de valeurs glissantes de dérivées de poids de taille N, N étant un entier.

Selon une autre caractéristique, la référence de dérivée de poids est calculée à partir des données géométriques liées à la forme physique du cristal à obtenir.

Les caractéristiques et avantages de la présente invention ressortiront mieux de la description qui va suivre, donnée en référence aux dessins annexés dans lesquels :

la figure 1 est une vue de face représentant de façon schématique une machine de tirage de monocristaux dans laquelle est mis en œuvre le procédé conforme à l'invention,

la figure 2 est une vue de côté, en coupe partielle et à plus grande échelle, représentant plus en détail, la partie supérieure de la broche de tirage et le chariot qui la supporte dans cette machine,

la figure 3 est une vue comparable à la figure 2 et illustre plus particulièrement la transmission des signaux entre la broche de tirage et les circuits de traitements de ces signaux, ces circuits étant reliés à un calculateur de contrôle,

la figure 4 représente schématiquement un lingot de monocristal obtenu, selon le procédé de l'invention mis en œuvre dans la machine précédente,

la figure 5 permet de mieux comprendre le calcul des vitesses de translation de la broche et du creuset pour la machine précédente mettant en œuvre le procédé de l'invention,

la figure 6 est un diagramme qui permet de mieux comprendre la manière d'écrêter les signaux qui rentrent dans l'action proportionnelle et intégrale permettant selon le procédé de l'invention, de réguler la température des moyens de chauffage de la machine,

la figure 7 est un diagramme représentant la variation, du rapport signal/bruit pour l'information dérivée de poids après le traitement numérique utilisé dans le procédé de l'invention,

la figure 8 représente deux tableaux I et II des résultats qui découlent de la figure 7 utiles dans le procédé de l'invention,

la figure 9 représente les variations de poids détectées par le capteur, au cours des principales

3

opérations de trempe, régulation et tirage automatiques, du procédé de l'invention,

la figure 10 est un organigramme général du procédé de l'invention,

la figure 11 est un organigramme relatif à la trempe automatique du germe, selon le procédé de l'invention,

la figure 12 est un organigramme relatif à la régulation à croissance nulle, selon le procédé de l'invention,

la figure 13 est un organigramme relatif au tirage ou croissance du monocristal, selon le procédé de l'invention.

La machine de tirage dans laquelle est mis en œuvre le procédé de l'invention est plus précisément celle qui est décrite dans la demande de brevet européen n° 8 314 219 déposée le 6 septembre 83 au nom du même demandeur.

La machine de tirage permettant de mettre en œuvre le procédé de l'invention se distingue essentiellement des autres machines connues au niveau de la tête de tirage, c'est-à-dire au niveau des moyens permettant de commander la translation verticale de la broche de tirage le long de son axe et des moyens pour commander la rotation de la broche autour de cet axe.

De plus, lorsque le bain fondu se transforme en monocristal au fur et à mesure de la montée de la broche de tirage, il se produit une baisse du niveau de ce bain dans le creuset qui nécessite, pour garder constante la vitesse de croissance du cristal et pour conserver fixe dans le gradient thermique, la position de l'interface solide-solide, de déplacer d'un mouvement lent le creuset vers le haut. Les moyens pour commander le déplacement du creuset ne seront pas décrits ici en détail.

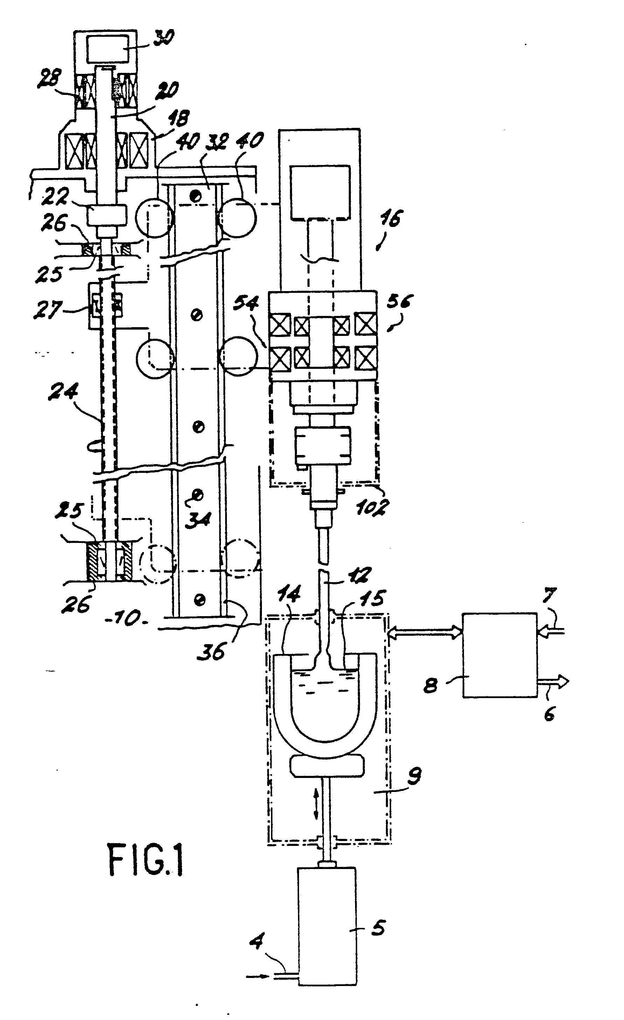

Sur la figure 1, on a représenté une partie du bâti 10 de la machine, supportant la broche de tirage 12, d'axe vertical, au-dessus du creuset 14 rempli d'un bain 15 de produit fondu à cristalliser, par l'intermédiaire d'un chariot 16 mobile verticalement par rapport au bâti 10. Le creuset est situé dans un four 9, représenté schématiquement. Ce four est associé à des moyens de chauffage résistifs ou haute fréquence qui ne sont pas décrits ici en détail. Ces moyens 8 reçoivent des signaux de régulation sur des entrées 7 et fournissent des signaux de mesures sur des sorties 6. Le creuset peut être déplacé en translation parallèlement à la broche de tirage 12, par des moyens de commande 5. Ces moyens reçoivent sur des entrées 4, des signaux de contrôle fournis par un calculateur, comme on le verra plus loin en détail.

La commande du déplacement vertical du chariot 16 par rapport au bâti 10 est réalisée par un moteur couple 18 monté à la partie supérieure du bâti, de façon à entraîner directement en rotation un arbre 20, d'axe vertical, dont l'extrémité inférieure est solidarisée par un accouplement 22 d'une tige filetée d'axe vertical 24 montée de façon tournante dans des tourillons 26 solidaires du bâti 10, par l'intermédiaire de roulements 25. Comme tous les autres roulements de la machine, les roulements 25 sont des roulements sans jeu à contact oblique ou à gorge profonde.

Un écrou 27, solidaire du chariot 16 est reçu sur la tige filetée 24, de telle sorte que l'entraînement de celle-ci en rotation par le moteur couple 18 a pour effet de déplacer le chariot 16 selon un mouvement de translation verticale.

L'utilisation d'un moteur couple 18 permet des mouvements particulièrement doux et supprime les réducteurs et les embrayages utilisés dans les machines connues. De plus, un seul moteur couple permet de commander à la fois les déplacements lents (vitesse de translation comprise à volonté entre 1 et 30 mm par heure pour le tirage) et les déplacements rapides (vitesse de translation de 95 mm par minute pour l'approche) de la broche de tirage.

Afin d'assurer la régularité de ces déplacements, notament lors du tirage du monocristal, le moteur couple 18 est asservi en vitesse et en position. A cet effet, on associe au moteur 18 un capteur de vitesse tel qu'une dynamo tachymétrique 28 et un codeur de position tel qu'un synchro-résolveur 30. Pour simplifier, on n'a pas représenté sur la figure 1 les boucles d'asservissement par lesquelles les signaux délivrés par la dynamo tachymétrique et par le synchro-résolveur permettent d'asservir en vitesse et en position le moteur couple 18. De telles boucles d'asservissement sont en effet bien connues et ne sont pas décrites en détail.

La commande du moteur couple 18 à partir de l'armoire de commande, afin de régler la vitesse et le sens de déplacement de la broche de tirage 12, peut être réalisée par tout moyen approprié et ne sera pas décrite ici en détail.

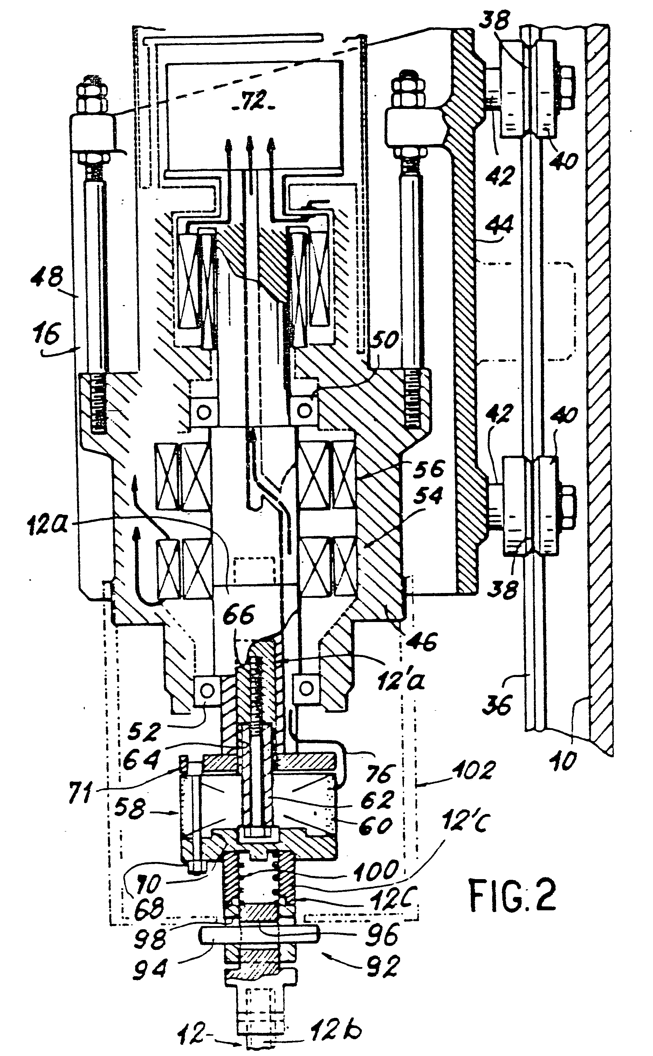

Le déplacement en translation verticale du chariot 16 portant la broche de tirage 12, par rapport au bâti 10, est guidé par des moyens appropriés distincts de l'ensemble vis-écrou 24, 27. Dans le mode de réalisation représenté sur les figures 1 et 2, ces moyens de guidage sont constitués par un rail ou une glissière verticale rectifiée 32 fixé sur le bâti 10, par exemple au moyen de vis 34, et dont les bords verticaux 36 présentent une section en forme de V. Ces bords 36 du rail 32 pénètrent dans des gorges 38 de même section formées dans au moins deux paires de galets rectifiés 40 décalées verticalement l'une par rapport à l'autre. Les axes 42 des galets 40 sont solidaires du chariot 16.

Bien entendu, ces moyens de guidage pourraient être constitués par tout autre moyen équivalent et notamment par un système de guidage à coussin d'air permettant de réduire les frottements et donc d'améliorer encore la régularité du déplacement du chariot 16 par rapport au bâti.

Quel que soit le moyen de guidage utilisé, il est à noter que le déplacement du chariot par rapport au bâti se fait sans à-coup ni vibration, ce qui constitue un avantage important par rapport à la technique antérieure.

Comme le montre en particulier la figure 2, le chariot 16 comprend une première partie 44 portant l'écrou 27 et les axes 42 supportant les galets de guidage 40 et une deuxième partie 46 présentant de façon générale une symétrie de révolution autour de l'axe vertical de la broche de tirage 12. La partie 46 du chariot est suspendue à la partie 44 par des tirants rigides 48, de longueur réglable, circonférentiellement répartis autour de la broche, de façon à permettre un réglage très précis de l'orientation verticale de l'axe de la broche.

On voit également sur la figure 2 que la partie supérieure de la broche de tirage 12 pénètre dans la partie 46 du chariot, dans laquelle elle est suspendue de façon tournante par l'intermédiaire d'une butée 52 et d'un roulement 50, également sans jeu. L'entraînement en rotation de la broche 12 à l'intérieur de la partie 46 du chariot est réalisé à l'aide d'un deuxième moteur couple 54, asservi en vitesse au moyen d'un capteur de vitesse tel qu'une dynamo tachymétrique 56 et d'un circuit d'asservissement connu (non représenté). Il est à noter que le moteur couple 54 est en prise directe sur la broche 12. De la même manière que pour le moteur 18, la commande du moteur 54 peut être réalisée par tout moyen approprié et ne sera pas décrite ici en détail.

Comme pour le moteur de commande de translation 18, le moteur couple 54 permet un mouvement particulièrement doux et supprime tout réducteur mécanique. Le moteur couple 54 permet d'imprimer à la broche de tirage un mouvement de rotation réglable entre 0 et 100 tours par minute.

La stabilité de vitesse obtenue grâce à l'utilisation des moteurs couples 18 et 54 est meilleure que 2,5 pour cent, ce qui constitue un résultat très supérieur aux résultats obtenus à l'aide des machines de tirages connues, la machine décrite ici ne comportant aucun multiplicateur.

Pour réaliser la trempe automatique du germe dans le bain contenu dans le creuset, on interpose un capteur de poids 58 directement dans la broche de tirage 12.

Lors de la croissance du cristal et comme on le verra plus loin en détail, la pesée réalisée à l'aide du capteur 58 représente, au poids de la partie inférieure de la broche de tirage près, la pesée du monocristal, et elle permet donc d'intervenir sur la puissance de chauffage du creuset afin de réguler le diamètre du cristal obtenu. Le capteur 58 présente une structure particulière permettant d'éviter tout décalage gênant entre les axes des deux parties de la broche reliées par le capteur.

De façon connue, le capteur de poids 58 se compose d'une pièce externe 60 et d'une pièce interne 62 entre lesquelles sont disposés des capteurs de déformation (non représentés) tels que des jauges de contrainte.

Afin d'améliorer l'alignement des axes de la partie supérieure 12a et de la partie inférieure 12b de la broche de tirage 12, on voit sur la figure 2 que la pièce centrale 62 se prolonge vers le haut en saillie au-dessus de la face supérieure de la pièce externe 60, pour pénétrer dans un trou borgne 64 formé dans la partie 12a de la broche, à laquelle elle est fixée par une vis 66. De façon comparable, la pièce externe 60, qui est fixée à la partie inférieure 12b de la broche de tirage par des vis 68, est centrée par rapport à cette partie 12b au moyen d'un embrèvement 70. Ainsi, l'alignement des axes des deux parties de la broche de tirage peut être obtenu avec une bonne précision.

On voit aussi sur la figure 2 qu'un disque 71, de même diamètre que la pièce externe 60, est fixé au-dessus de celle-ci à l'extrémité inférieure de la partie 12a de la broche, par exemple au moyen de vis (non représentées). Ce disque 71, qui définit avec la pièce 60 un intervalle relativement petit, constitue une butée servant à contrebalancer les efforts radiaux ou de compression qui pourraient être accidentellement appliqués au capteur. Pour une bonne efficacité de cette butée, l'intervalle entre le disque 71 et la pièce 60 est, de préférence, limité à 1/10 de mm environ.

Afin d'améliorer la stabilité du système vis-à-vis des fluctuations thermiques environnantes, on voit sur la figure 2 que le capteur de poids 58, ainsi que toute la zone de la broche de guidage située entre l'extrémité inférieure de la partie 46 du chariot et le dispositif démontable 92 qui sera décrit ultérieurement, sont logés dans une enceinte 102. Cette enceinte 102 est réalisée en aluminium poli sur ses faces interne et externe.

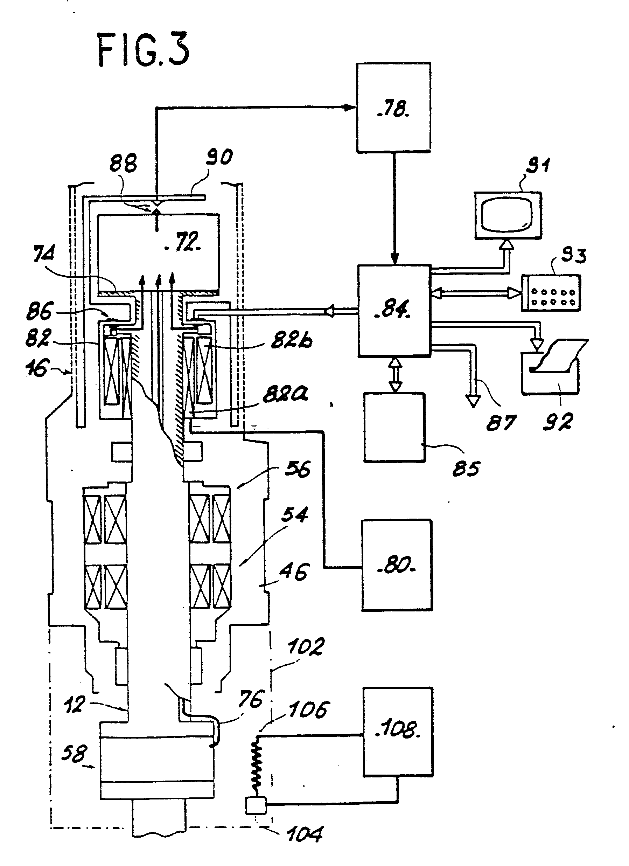

De plus, des moyens sont prévus pour réguler la température à l'intérieur de l'enceinte 102. Ces moyens comprennent une sonde de température 104 et un organe de chauffage 106 fixés à l'intérieur de l'enceinte 102, ainsi qu'un circuit de régulation électronique 108 logé dans la console de commande (non représentée). La sonde 104 et l'organe de chauffage 106 sont reliés électriquement au circuit 108 comme l'illustre schématiquement la figure 3, de telle sorte que l'organe de chauffage, commandé par le circuit 108, permette de stabiliser la température en fonction des informations délivrées par la sonde de température. La température sur le capteur de poids peut ainsi être stabilisée par exemple au voisinage de 35 °C environ. En outre, afin d'éliminer les ponts thermiques qui existent entre le milieu extérieur et le capteur de poids 58, les parties 12'a et 12'c de la broche de tirage adjacentes au capteur sont réalisées en un matériau isolant tel que de l'alumine.

Afin de résoudre le problème de la transmission des signaux électriques délivrés par le capteur de poids 58 jusqu'aux parties non tournantes de la machine, on voit en se référant à la figure 3 qu'on a fait appel dans cette machine à différentes techniques de transmission selon la nature des signaux, ces techniques ayant en commun de supprimer tout contact électrique tournant entre la broche et la partie 46 du chariot 16.

En premier lieu, et afin de réduire autant que possible la longueur des fils électriques avant que les

5

**0 142 415**

signaux délivrés par le capteur 58 ne subissent un premier traitement, ce qui permet d'éviter la création de parasites qui pourraient être préjudiciables à la mesure, un premier circuit électronique ou circuit de traitement préliminaire 72 est embarqué directement sur un plateau 74 monté à l'extrémité supérieure de la broche de tirage 12, au-dessus de la partie 46 du chariot. Les fils 76 permettant d'acheminer jusqu'au circuit 72 les signaux électriques délivrés par le capteur 58 traversent des passages appropriés formés dans la partie supérieure 12a de la broche de tirage, comme on l'a représenté sur les figures 2 et 3.

Le circuit de traitement 72 a principalement pour fonctions d'amplifier le signal en provenance du capteur de poids, de multiplexer ce signal amplifié ainsi que des grandeurs analogiques annexes telles que des mesures de températures, puis de convertir toutes ces grandeurs en un train d'impulsions dans un convertisseur tension-fréquence, par exemple à 1 MhZ.

Compte tenu des différentes fonctions du circuit de traitement 72, on voit que trois types de grandeurs devront circuler entre le circuit 72, l'alimentation 80 et un calculateur de contrôle 84 relié à une mémoire 85. Ce calculateur est aussi relié à un appareil de visualisation 91, à une imprimante 92, et à un clavier d'introduction de données 93.

Les trois types de grandeurs sont :

la tension d'alimentation délivrée par la source de tension 80 qui alimente le primaire 82a du transformateur tournant dont le secondaire 82b alimente le circuit 72,

les ordres de multiplexage des grandeurs conditionnées dans le circuit 72 ainsi que des ordres de contrôle qui seront décrits plus loin, sont délivrés par le calculateur 84 ; d'autres sorties 87 du calculateur fournissent des signaux de contrôle appliqués sur les entrées 7 des moyens de chauffage 8 du four 9 et sur les entrées 4 des moyens 5 de commande de translation du creuset 14 et de rotation-translation de la broche de tirage,

les informations délivrées par le circuit 72 et qui doivent être transférées jusqu'au circuit de traitement principal 78 logé dans la console.

En premier lieu et comme l'illustre la figure 3, la tension d'alimentation du circuit 72 délivrée par la source 80 est transmise de la partie 46 du chariot 16 au circuit 72 tournant avec la broche 12 par un transformateur tournant 82 dont le primaire 82a est solidaire de la partie 46 et disposé à l'intérieur du secondaire 82b, solidaire de la broche 12.

D'autre part, les ordres de contrôle délivrés par le calculateur 84, sont transmis au circuit 72 entre la partie 46 et la broche 12, par l'intermédiaire d'un système de couplage capacitif 86, par exemple sur une porteuse à 3 MhZ.

Enfin, les informations fournies sous la forme d'un train d'impulsions par le circuit de traitement 72 sont transmises au circuit de traitement principal 78 par un système électro-optique constitué par deux photodiodes 88 placées selon l'axe de la broche 12, disposées en vis-à-vis, et solidaires respectivement du circuit embarqué 72 et d'une plaque 90 fixée à la partie 46 du chariot.

Afin de permettre l'interchangeabilité de la partie de la broche 12 portant le germe, on voit sur la figure 2 que la partie inférieure 12b de la broche est montée par un dispositif démontable 92 sur une partie intermédiaire 12c, elle-même reliée à la partie supérieure 12a par l'intermédiaire du capteur de poids 58.

De façon plus précise, le dispositif démontable 92 est constitué par une goupille 94 qui pénètre simultanément dans des trous 96 et 98, par exemple de forme carrée, formés respectivement dans les extrémités complémentaires des parties 12b et 12c de la broche de tirage. Le maintien en position de la goupille dans les trous est obtenu par un ressort 100. Ce dispositif présente l'avantage de permettre un démontage très facile de la partie inférieure 12b en exerçant une légère pression vers le haut à l'encontre du ressort 100, de façon à dégager la goupille 94 des trous 96 et 98. De plus, ce dispositif assure un centrage parfait sans jeu longitudinal ni rotatif.

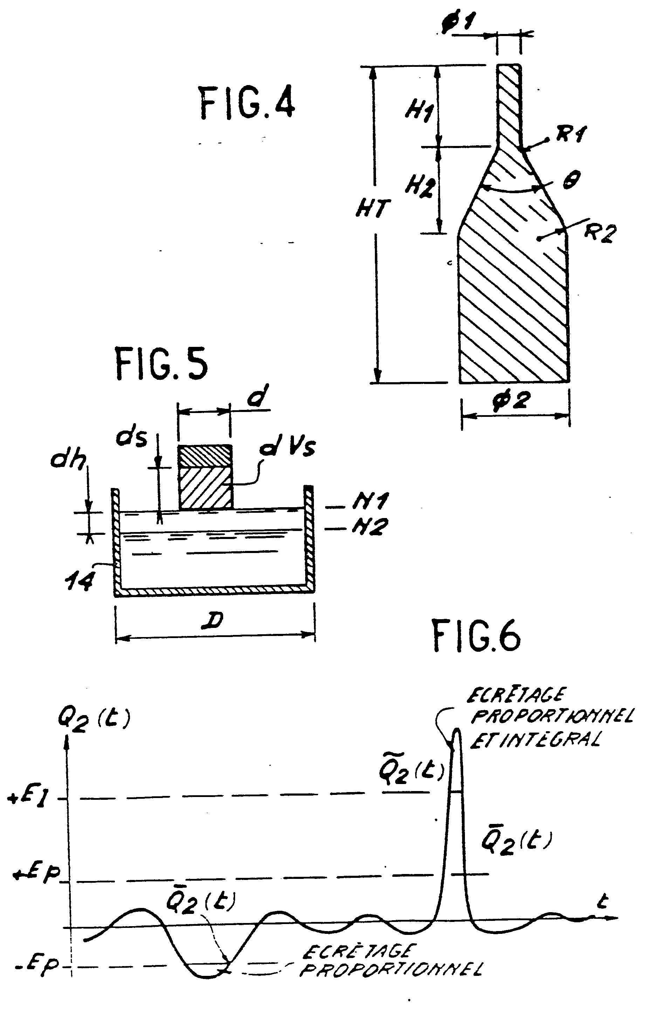

La figure 4 représente schématiquement un monocristal tel qu'il est possible d'obtenir par la méthode de tirage de type Czochralski, à l'aide de la machine décrite plus haut et grâce à la mise en œuvre du procédé de l'invention qui sera décrit plus loin en détail. A ce monocristal correspondent des paramètres géométriques importants ainsi que d'autres paramètres physiques ; les paramètres géométriques sont représentés sur la figure 4 et sont les suivants :

$\emptyset_1$ : diamètre du germe,

$\emptyset_2$ : diamètre du lingot de monocristal,

$H_1$ : longueur du germe,

$H_2$ : longueur de la tête du lingot de monocristal,

$\theta$ : angle de la partie conique de la tête de lingot de monocristal,

$R_1/R_2$ : rapport des rayons correspondant respectivement aux raccordements du germe avec la tête du lingot et de la tête de lingot avec la partie cylindrique de ce lingot,

$H_t$ : hauteur totale du lingot correspondant à la somme des longueurs du germe, de la tête du lingot et du corps de ce lingot.

Les autres paramètres physiques qui interviennent dans la définition du monocristal que l'on souhaite obtenir à l'aide de la machine décrite plus haut et par la mise en œuvre du procédé de l'invention sont : la densité du liquide de produits fondus servant à tirer le monocristal, la densité du monocristal solide, le poids total du monocristal. Enfin, d'autres paramètres importants sont : la vitesse linéaire de cristallisation $v_s$, le rapport $PC = v_c/v_h$ ($v_c$ désignant la vitesse de montée $v_c$ du creuset et $v_h$ désignant la

6

vitesse de descente du liquide dans le creuset), la durée du tirage, la durée de la formation de la tête de ce monocristal (située entre le germe et la partie cylindrique du monocristal).

Ces différents paramètres sont enregistrés dans la mémoire 85 du calculateur 84 et vont servir à définir dans le procédé de l'invention, d'une part la vitesse du tirage du monocristal et, d'autre part, le contrôle de la régulation du four par mesure des poids successifs du lingot de monocristal, au cours du tirage.

La figure 5 permet de mieux comprendre comment sont calculées les vitesses de translation de la broche et du creuset, en fonction du niveau du bain de produits fondus dans ce creuset, sachant que ce niveau doit être situé dans un gradient de température constant, pour que le tirage du monocristal s'effectue dans de bonnes conditions, et notamment, que les paramètres géométriques qui définissent la forme de ce monocristal, soient respectés. Sur cette figure, on désigne par $N_1$ le niveau des produits en fusion dans le creuset 14 à l'instant t, et par $N_2$ le niveau de ces produits, à un instant t + dt, au cours du tirage. Pendant l'intervalle de temps dt, une masse $d_m$ occupant un volume $dv_s$ (représenté en hachure sur la figure) de produits, se cristallise.

Le volume $dv_s$ de solides cristallisés pendant le temps dt peut être exprimé par la formule :

$$dv_s = \pi \times \frac{d^2}{4} \times ds \,.$$

(d étant le diamètre de tirage).

Dans cette formule, ds représente la hauteur de monocristal formé pendant l'intervalle de temps dt, au-dessus du niveau du bain de produits fondus.

Pendant ce même intervalle de temps, le niveau de produits en fusion dans le creuset est passé du niveau $N_1$ au niveau $N_2$. La différence de ces niveaux est représentée par dh sur la figure.

De la même façon que l'on a exprimé le volume $dv_s$ de produits cristallisés pendant un intervalle de temps dt, il est possible d'exprimer le volume $dv_h$ de produits en fusion, qui a disparu du creuset, par la relation :

$$dv_h = \pi \times \frac{D^2}{4} \times dh$$

(D étant le diamètre interne du creuset).

En fait, la masse de cristal solide formée, correspondant à la masse de produits en fusion disparue du creuset ; il est donc possible d'écrire :

$$ds \times \pi \times \frac{d^2}{4} \times \rho s = \rho l \times \pi \times \frac{D^2}{4} \times dh \,.$$

Dans cette relation $\rho s$ et $\rho l$ désignent respectivement les densités du solide monocristallin formé et des produits en fusion dans le creuset.

Si l'on désigne respectivement par $v_h$ et $v_s$ les vitesses de descente du produit en fusion dans le creuset et de cristallisation de ce produit au cours du tirage, il est possible d'écrire :

$$v_h = \frac{dh}{dt} \quad et \quad v_s = \frac{ds}{dt} \,.$$

Le rapport de ces vitesses est donc égal à :

$$\frac{v_h}{v_s} = \frac{\rho s}{\rho l} \times \frac{d^2}{D^2} = \frac{\dfrac{dh}{dt}}{\dfrac{ds}{dt}} = RA \,.$$

La vitesse de tirage (qui peut aussi être appelée vitesse de translation de la tête) peut être exprimée par la relation : $v_t = v_s - v_h + v_c$.

Cette vitesse de tirage peut aussi s'exprimer en fonction des rapports RA et PC définis plus haut, de la manière suivante :

$$v_t = v_s - v_h + v_c = v_s \ (1 - RA + PC \times RA) \,.$$

De la même manière, la vitesse de translation du creuset $v_c = PC \times v_h = PC \times RA \times v_s$.

Un certain nombre de paramètres supplémentaires, qui permettent la mise en œuvre du procédé de l'invention vont maintenant être définis. Ces paramètres sont les suivants :

la période d'échantillonnage PE ; cette période d'échantillonnage est prédéterminée et elle correspond à l'intervalle de temps $\Delta t$ qui sépare chaque mesure de poids effectuée à l'aide du capteur par

**0 142 415**

la chaîne de mesure. Chacune de ces mesures est représentée par des signaux qui sont appliqués au circuit électronique de traitement 78 (figure 3),

l'intervalle de temps TC au cours duquel le calculateur va effectuer une intégration du signal poids du monocristal. En effet, le signal de poids en provenance du capteur est, après conditionnement par le circuit de traitement, converti en un train d'impulsions ; ces impulsions sont accumulées dans une échelle de comptage du calculateur, cette échelle de comptage présentant un temps d'intégration TC programmable. La lecture du contenu de ce compteur est significative du poids, elle est assurée par le calculateur au rythme de l'intervalle d'échantillonnage PE.

Les valeurs successives de poids qui sont ainsi obtenues sont entâchées des fluctuations causées par les vibrations mécaniques de la machine. Il s'ensuit donc des fluctuations sur l'extraction des dérivées de poids utilisées comme grandeurs pertinentes pour la régulation du processus de croissance. Comme nous le verrons par la suite, un processus de filtrage par moyenne glissante est utilisé pour diminuer l'influence de ces fluctuations. Les paramètres qui permettent d'ajuster ce filtrage sont :

le nombre M d'intervalles d'échantillonnage qui représente l'écart de temps sur lequel est pris la dérivée de poids ;

le nombre N de dérivées de poids stockées en mémoire utilisées à chaque instant pour extraire par moyennage la dérivée de poids filtrée.

Enfin, des paramètres complémentaires utiles pour la conduite du procédé sont les suivants :

la valeur limite de la tension de commande du four (tension qui est régulée sous le contrôle du calculateur) comme on le verra plus loin en détail,

la durée de refroidissement du four (à la fin du tirage du monocristal),

le sens de rotation de la broche au cours du tirage,

la vitesse de rotation de cette broche : $v = f(t)$,

la constante de régulation proportionnelle $P(t)$,

la constante de régulation intégrale $I(t)$. Ces constantes de régulations seront définies plus loin.

La vitesse de rotation de la broche et les constantes de régulation proportionnelle et intégrale sont des paramètres importants dans le contrôle de la croissance cristalline ; en effet, les conditions thermiques changent considérablement par suite de la disparition de produits en fusion dans le creuset au profit d'une apparition de produits solides cristallisés. Pour suivre ces changements, ces paramètres varient en fonction du temps, comme on le verra plus loin en détail.

un écrêtage de la dérivée de poids filtrée est réalisé avant introduction dans le terme proportionnel. Cet écrêtage est défini par un paramètre de seuil EP,

un autre écrêtage de la dérivée de poids filtrée est réalisé avant introduction dans le terme intégral. Cet écrêtage est défini par un paramètre de seuil EI.

Ces écrêtages sont réalisés car il est nécessaire d'éviter que ne rentrent dans les termes proportionnel et intégral des mesures aberrantes sans signification physique. Ces opérations sont faites dans certaines conditions qui vont maintenant être définies de manière plus précise.

De manière connue en théorie des servo-mécanismes, si PE ou $\Delta t$ désigne l'intervalle d'échantillonnage, $P(t)$ la constante proportionnelle et $I(t)$ la constante intégrale de la boucle de régulation, il est possible de calculer à chaque instant $t$, l'action à appliquer sur l'organe de chauffage, en fonction de l'écart de la dérivée de poids à sa référence.

L'écart $Q_2(t)$ de dérivée de poids, par rapport à la référence $V_1(t)$ peut alors être exprimé par la relation :

$$Q_2(t) = V_1(t) - Q_1(t)$$

Dans cette relation $Q_1(t)$ désigne la dérivée de poids mesurée après filtrage.

La figure 6 permet de mieux comprendre l'écrêtage des actions proportionnelle et intégrale.

En ce qui concerne l'écrêtage du terme intégral, celui-ci est opéré en fonction des considérations suivantes :

Si $|Q_2(t)| > EI$, alors l'écart $\tilde{Q}_2(t)$ avec la référence, qui entre dans le terme intégral, s'exprime par la relation : $\tilde{Q}_2(t) = EI$ (affecté du signe de $Q_2(t)$),

Si $|Q_2(t)|$ n'est pas supérieur à EI, $\tilde{Q}_2(t) = Q_2(t)$.

L'intégrale $Q_3(t)$ de l'écart de la dérivée de poids au temps $t$, s'exprime par la relation d'affectation :

$$Q_3(t) = Q_3(t - PE) + \tilde{Q}_2(t) \pm PE/I(t)$$

Relation dans laquelle $I(t)$ représente la constante intégrale.

L'écrêtage du terme proportionnel se traduit de la manière suivante :

Si $|Q_2| > EP$, alors l'écart avec la référence pour la constante proportionnelle s'exprime par la relation : $\overline{Q}_2(t) = EP$ (affecté du signe de $Q_2(t)$),

Si $|Q_2|$ n'est pas supérieur à EP, $\overline{Q}_2(t) = Q_2(t)$.

L'action proportionnelle et intégrale est affectée à la variable $Q_4(t)$. Cette action pondérée est liée à l'écart de la dérivée de poids par rapport à sa référence :

8

$$Q_4(t) = P(t) \pm \overline{Q}_2(t) + Q_3(t) \tag{1}$$

Dans cette relation, P(t) représente la constante proportionnelle, $\overline{Q}_2(t)$ représente l'écart de la dérivée de poids par rapport à sa référence, cet écart étant écrêté par la constante d'écrêtage proportionnelle, $Q_3(t)$ étant le terme intégral.

C'est à partir de la relation (1) que le calculateur 84 va piloter au cours du tirage la tension de commande du moyen de chauffage.

Les considérations suivantes vont permettre de mieux comprendre l'utilisation des mesures de poids au cours du tirage selon le procédé de l'invention. On désigne par P(t) la grandeur représentative du poids au cours du temps, échantillonné à intervalles de temps réguliers $\Delta t$ ou PE.

La dérivée dp/dt de la fonction P(t) se calcule en faisant la différence entre deux mesures espacées de $M \times \Delta t$, normée par $M \times \Delta t$. Pour améliorer la précision du résultat, on effectue la moyenne arithmétique sur N termes successifs :

$$\frac{dP}{dt} \simeq \frac{1}{N} \sum_{k=1}^{N} \frac{P(t + (M + k)\Delta t) - P(t + k\Delta t)}{M \times \Delta t}$$

Dans cette relation, M, N et k sont des entiers.

Le calcul de cette dérivée nécessite la connaissance de M + N valeurs échelonnées sur une durée de $(M + N - 1)\Delta t$. Pour une durée $A \cdot \Delta t = (M + N - 1)\Delta t$ fixée, on cherche à trouver les valeurs des paramètres M et N de telle façon que la valeur obtenue soit la plus significative possible.

Comme cela a pu être vérifié dans le procédé de l'invention, qui sera décrit plus loin en détail, les mesures de poids sont toutes indépendantes entre elles, et peuvent être assimilées à des lois normales bien connues en mathématique.

Soit P(t) la mesure de poids à l'instant t, P(t) suit la loi normale de vapeur moyenne P et d'écart type $\theta$, notée $\mathcal{N}(P, \theta)$. A l'instant $t + \Delta t$, $P(t + \Delta t)$ suit la loi normale $\mathcal{N}(P + \Delta P, \theta)$. Pendant l'intervalle $\Delta t$ le poids moyen a augmenté de $\Delta P$. $\theta$ est une constante instrumentale, elle peut être estimée d'une manière statistique. La différence de poids $\delta(t) = P(t + \Delta t) - P(t)$ suit la loi normale $\mathcal{N}(\Delta P, \sqrt{2} \cdot \theta)$ ou $\mathcal{N}(\Delta P, \sigma)$ en désignant par $\sigma$ la valeur $\sqrt{2} \cdot \theta$. Il est utile de rappeler que si $X_1$ suit la loi normale $\mathcal{N}(m_1, \theta_1)$ et $X_2$ suit la loi normale $\mathcal{N}(m_2, \theta_2)$, alors $X_1$-$X_2$ suit la loi normale $\mathcal{N}(m_1$-$m_2, \sqrt{\theta_1^2 + \theta_2^2})$.

En considérant maintenant M intervalles de longueur $\Delta t$ et en appelant $D_i$ la différence $P(M + i)\Delta t - P(i\Delta t)$, ou plus simplement $P_{M+i} - P_i = D_i$ (i étant un entier), tel que représenté sur le diagramme ci-après,

la différence $D_i = P_{M+i} - P_i$ suit la loi normale $\mathcal{N}(M \cdot \Delta P, \sigma)$.

Considérons N différences successives $[D_i...D_k...D_{i+N-1}]$. Ces différences constituent une famille de lois normales $\mathcal{N}(M\Delta P, \sigma)$. Si on étudie l'indépendance des termes $D_k$ de ces différences, on s'aperçoit que $D_i$ et $D_{i+M}$ par exemple ne peuvent pas être indépendantes, car elles possèdent un terme en commun : $P_{M+i}$.

$$D_i = P_{M+i} - P_i$$
$$D_{i+M} = P_{2M+i} - P_{M+i}$$

Si $N \leqslant M$, les variables aléatoires $[D_i,...,D_{i+N-1}]$ sont bien indépendantes, car les différences ne font intervenir que des poids différents. Si on écrit la moyenne des $D_k$ pour $k = i,...i + N - 1$ :

$$\overline{D} = \sum_{k=i}^{i+N-1} \frac{D_k}{N} .$$

Cette grandeur suit d'après le théorème central limite connu en statistique la loi normale

$$\mathcal{N}\left(M \Delta P, \frac{\sigma}{\sqrt{N}}\right),$$

et $dP/dt = \overline{D}/(M \cdot \Delta t)$ suit la loi normale

$$\mathcal{N}\left( \frac{\Delta P}{\Delta t} , \frac{\sigma}{\sqrt{N} \cdot M \cdot \Delta t} \right)$$

Si $N > M$, l'indépendance des variables aléatoires n'est plus vraie. Lorsque l'on forme la somme des valeurs $D_k$, certains termes se simplifient. Par exemple $D_i + D_{M+i} = P_{M+i} - P_i + P_{2M+i} - P_{M+i} = P_{2M+i} - P_i$. On retrouve une différence de poids sur un intervalle $2M \times \Delta t$. Un exemple simple permettra maintenant de mieux comprendre le principe des variables indépendantes.

On choisit par exemple $M = 4$ et $N = 10$ d'où, avec les notations précédentes : $D_i = P_{i+4} - P_i$ pour $i = 1,...10$. Lorsque la somme de $D_i$ est écrite par paquets de 4 termes, on a les familles suivantes :

$$(P_5 - P_1) + (P_6 - P_2) + (P_7 - P_3) + (P_8 - P_4) \quad (P_9 - P_5) + (P_{10} - P_6) + (P_{11} - P_7) + (P_{12} - P_8)$$
$$(P_{13} - P_9) + (P_{14} - P_{10})$$

Appelons $D_k$ la somme de chaque colonne du tableau ci-dessus, pour $k = 1,...,4$, on a alors :

$$\tilde{D}_1 = P_{13} - P_1, \quad \tilde{D}_2 = P_{14} - P_2, \quad \tilde{D}_3 = P_{11} - P_3, \quad \tilde{D}_4 = P_{12} - P_4 .$$

Ces quatre variables aléatoires sont maintenant bien indépendantes et :

$\tilde{D}_1$ suit la loi normale $\mathcal{N}(12\Delta P, \sigma)$, $\tilde{D}_2$ suit la loi normale $\mathcal{N}(12\Delta P, \sigma)$, $\tilde{D}_3$ suit la loi normale $\mathcal{N}(8\Delta P, \sigma)$, $\tilde{D}_4$ suit la loi normale $\mathcal{N}(8\Delta P, \sigma)$ pour 4 variables, on a alors :

$$\bar{D} = \sum_1^4 \frac{\tilde{D}_k}{4} = \sum_1^2 \frac{\tilde{D}_k}{4} + \sum_3^4 \frac{\tilde{D}_k}{4}$$

$(1/4)(\tilde{D}_1 + \tilde{D}_2)$ suit la loi normale $\mathcal{N}(6\Delta P, \sigma\sqrt{2/4})$, $(1/4)(\tilde{D}_3 + \tilde{D}_4)$ suit la loi normale $\mathcal{N}(4\Delta P, \sigma\sqrt{2/4})$. Donc $\bar{D}$ suit la loi normale $\mathcal{N}(10\Delta P, \sigma/2)$ et, d'une façon générale, la loi normale $\mathcal{N}(N \cdot \Delta P, \sigma/\sqrt{M})$. On a alors $dP/dt = \bar{D}\sigma/N \cdot \Delta t$ qui suit la loi normale

$$\left( \frac{P}{\Delta t} , \frac{\sigma}{\sqrt{M \cdot N \cdot \Delta t}} \right) .$$

D'une manière générale, si on désigne par a le quotient et b le reste de la division entière de N par M, $N = a \times M + b$. Si on dispose les valeurs $D_k$ suivant M colonnes, on obtient a lignes complètes plus une ligne incomplète de b termes comme le montre le tableau qui suit. On appelle $\tilde{D}_k$ la somme des termes contenus dans la $k^{ième}$ colonne :

$$\begin{cases} \tilde{D}_k = P_{i+(a+1)M+k-1} - P_{i+k-1} & \text{avec } 1 \leq k \leq b-1 \\ \tilde{D}_k = P_{i+aM+k} - P_{i+k} & \text{avec } b \leq k \leq M \end{cases}$$

La famille de variables aléatoire $D_k$ est indépendante.
Le tableau est alors le suivant :

M colonnes

$$
\begin{array}{llll}
D_i & D_{i+b-1} & D_{i+b} & D_{i+M-1} \\
D_{i+M} & D_{i+M+b-1} & D_{i+M+b} & D_{i+2M-1} \\
& & & \\
& & & \text{a lignes} \\
& & & \\
D_{i+(a-1)M} & D_{i+(a-1)M+b-1} & D_{i+(a-1)M+b} & D_{i+aM-1} \\
D_{i+aM} & D_{i+aM+b-1} & &
\end{array}
$$

b termes

$\bar{D}_1 = (P_{i+(a+1)M} - P_i),...., \quad \bar{D}_b = (P_{i+(a+1)M+b-1} - P_{i+b-1})$ qui suivent la loi normale $\mathcal{N}((a+1)M\Delta P, \sigma)$, $\bar{D}_{b+1} = (P_{i+aM+b} - P_{i+b}),...., \quad \bar{D}_M = (P_{i+(a+1)M-1} - P_{i+M-1})$ qui suivent la loi normale $\mathcal{N}(aM\Delta P, \sigma)$ avec la valeur moyenne :

$$\bar{D} = \sum_{k=1}^{M} \frac{\tilde{D}_k}{M} = \sum_{1}^{b} \frac{\tilde{D}_k}{M} + \sum_{b+1}^{M} \frac{\tilde{D}_k}{M}$$

$\sum_{1}^{b} \frac{\tilde{D}_k}{M}$ suit la loi normale $\mathcal{N}\left( b(a+1)\Delta P, \sigma \sqrt{\frac{b}{M}} \right)$

$\sum_{b+1}^{M} \frac{\tilde{D}_k}{M}$ suit la loi normale $\mathcal{N}\left( a(M-b)\Delta P, \sigma \sqrt{\frac{M-b}{M}} \right)$

Or $b(a+1)\Delta P + a(M-b)\Delta P = (aM+b)\Delta P = N\Delta P$

D'où $\bar{D}$ suit la loi normale

$$\mathcal{N}\left( N\Delta P, \frac{\sigma}{\sqrt{M}} \right)$$

pour $N > M$

Cette formule est à rapprocher du cas $N \leqslant M$. Il suffit de permuter N et M.

$N \leqslant M$ ; dP/dt suit la loi normale

$$\mathcal{N}\left( \frac{\Delta P}{\Delta t}, \frac{\sigma}{\sqrt{N \cdot M \cdot \Delta t}} \right)$$

$N > M$ ; dP/dt suit la normale

$$\mathcal{N}\left( \frac{\Delta P}{\Delta t}, \frac{\sigma}{\sqrt{M \cdot N \cdot \Delta t}} \right)$$

On va alors chercher les valeurs optimales de M et N pour obtenir le meilleur rapport signal/bruit.

On pose $A = M + N - 1$ qui représente le nombre d'intervalles $\Delta t$ utilisés à chaque instant dans le calcul de la dérivée et de la moyenne glissante de cette dérivée.

Pour $N > M$, on va calculer la valeur S du rapport de la valeur moyenne de la loi normale à l'écart-type défini plus haut :

$$S = \frac{N \cdot \Delta P \sqrt{M}}{\sigma} = \frac{(A+1-M)\sqrt{M}}{\sigma} \cdot \Delta P$$

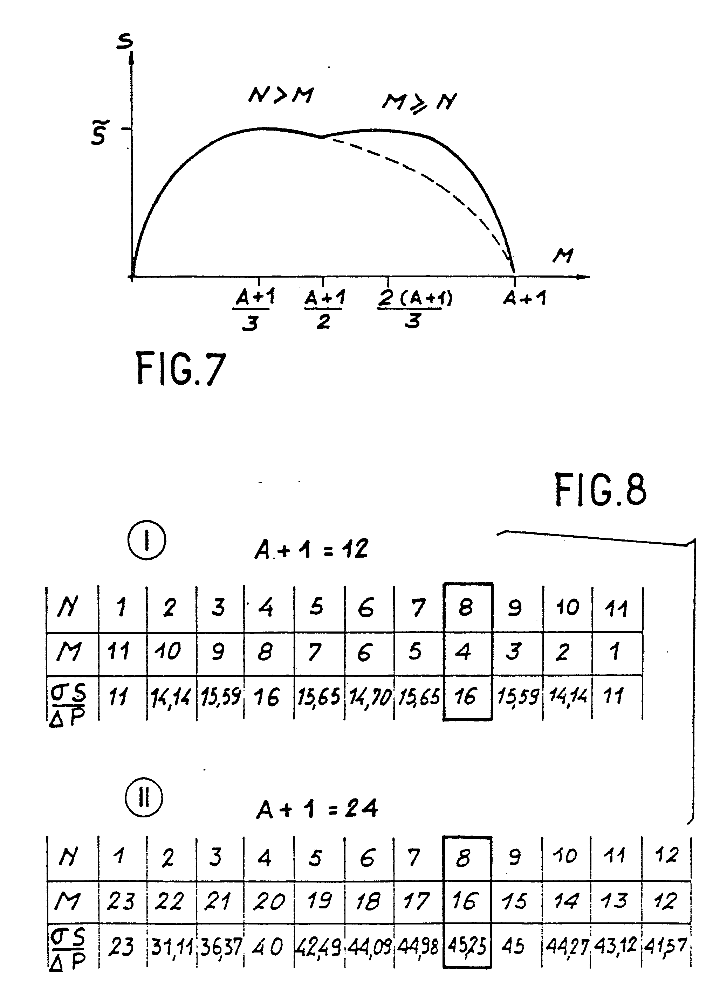

Cette fonction est représentée sur la figure 7.

Sa dérivée

$$\frac{dS}{dM} = \frac{\Delta P}{2\sigma} \left( \frac{A+1-3M}{\sqrt{M}} \right)$$

s'annule pour $M = (A+1)/3$ lorsque $N > M$.

L'optimum recherché est donc atteint pour $M = (A+1)/3$.

La valeur correspondante de S, pour cet optimum est :

$$\tilde{S} = \frac{2\Delta P}{\sigma} \left( \frac{A+1}{3} \right)^{3/2}.$$

Pour $N \leqslant M$, $S = M\Delta P\sqrt{N}/\sigma$, l'optimum est atteint quand $M = 2N = [2(A+1)]/3$ et :

$$\tilde{S} = \frac{2\Delta P}{\sigma} \left( \frac{A+1}{3} \right)^{3/2}$$

En conclusion pour un nombre A donné, il faut prendre N et M dans un rapport 2, afin de réaliser les conditions optimales.

Les tableaux 1 et 2 de la figure 8 donnent respectivement pour A + 1 = 12 et A + 1 = 24, les valeurs correspondantes de N, M et $\sigma \cdot S/\Delta P$. Ces tableaux montrent que pour A + 1 = 12 les valeurs optimales de N et M sont respectivement 8 et 4. Pour A + 1 = 24, les valeurs optimales de N et M sont respectivement 8 et 16.

On va maintenant étudier l'influence de la cadence d'échantillonnage sur ces résultats. On pose $\Delta P/\Delta t = C$ (constante), pour faire apparaître la période d'échantillonnage $\Delta t$ dans l'expression $\tilde{S}$.

$$\tilde{S} = 2\frac{C}{\sigma} \cdot \Delta t \left( \frac{A+1}{3} \right)^{3/2}$$

Dans toute la suite, on considèrera que $A \gg 1$. En pratique A est de l'ordre de 30 à 40.

Supposons par exemple que l'on diminue la période d'échantillonnage dans le rapport n, la nouvelle période d'échantillonnage s'écrit $\Delta t = \Delta t/n$. Sachant qu'on doit conserver le même écart de temps pour le calcul des différences successives, on doit multiplier par n la valeur de M, et :

$$M \times \Delta t = \hat{M} \cdot \widehat{\Delta t} \quad \text{avec} \quad \hat{M} = nM$$

Dans le but d'obtenir une comparaison aisée des mesures, il faut conserver également la même durée sur l'ensemble des mesures, et :

$$A \times \Delta t = \hat{A} \times \widehat{\Delta t} \quad \text{avec} \quad \hat{A} = nA$$

Or, on a toujours $A + 1 = M + N$ ou $\hat{A} + 1 = \hat{M} + \hat{N}$ d'où $\hat{N} = nA + 1 - nM = n(N - 1) + 1$.
Comparons $\tilde{S}$ et $\hat{S}$ (pour $\widehat{\Delta t} = \Delta t/n$) :

$$\tilde{S} = \frac{2C}{\sigma} \Delta t \left( \frac{A+1}{3} \right)^{3/2} \neq \frac{2C}{\sigma} \Delta t \left( \frac{A}{3} \right)^{3/2}$$

$$\hat{S} = \frac{2C}{\sigma} \frac{\Delta t}{n} \left( \frac{nA+1}{3} \right)^{3/2} \neq \frac{2C}{\sigma} \frac{\Delta t}{n} \left( \frac{nA}{3} \right)^{3/2}$$

$$\text{d'où } \hat{S} \simeq \sqrt{n} \cdot \tilde{S}.$$

On en déduit que l'augmentation de la cadence d'échantillonnage permet encore d'améliorer le rapport signal/bruit.

Le procédé de l'invention consiste à utiliser au mieux les informations issues du signal poids pour commander la machine de tirage.

La régulation de température s'effectue à partir de la dérivée de poids, par variation de la tension appliquée aux moyens de chauffage conformément aux explications données plus haut.

D'une part l'information poids doit pouvoir être conservée pendant un certain laps de temps (variable M définie plus haut) afin d'obtenir par différence des poids aux instants extrêmes séparés d'un intervalle de temps $M\Delta t$, une bonne approximation de la dérivée de poids. De cette façon, la variation de poids due à la croissance du monocristal est prépondérante par rapport au bruit.

D'autre part, pour améliorer encore la qualité de dérivée de poids, et comme indiqué plus haut, il est intéressant de prendre la moyenne arithmétique des N dernières différences de poids.

Ces considérations amènent la création de deux piles contenant les poids et les différences de poids. Ces piles sont formées dans la mémoire 85 du calculateur 84. La première pile qui contient les poids est une pile linéaire de type FIFO (« first in first out ») qui sert à calculer les différences de poids. La deuxième pile est une pile circulaire qui contient les différences de poids calculées plus haut. Elle est utilisée dans l'invention pour calculer la moyenne glissante des N différences de poids. Ces piles ne sont pas représentées en détail, leur principe étant connu dans l'état de la technique. Dans la première pile, tous les éléments de la pile glissent d'un rang, en éliminant la valeur la plus ancienne toujours située en bas, ensuite la nouvelle valeur du poids arrive au sommet de la pile. Pour chaque valeur de poids, tous les éléments de la pile sont déplacés d'un rang vers le haut. Le traitement de cette pile terminé, la différence $P(t) = P(M) - P(O)$ est calculée, différence des poids sur l'intervalle $M\Delta t$. Elle est transférée ensuite dans la seconde pile circulaire. Dans cette pile circulaire, une variable S contient en permanence la somme des N dernières différences. Un seul élément de pile, repéré par un pointeur d'accès variable, change à chaque manipulation. La valeur la plus ancienne est remplacée par la nouvelle.

De cette façon, la rapidité d'exécution des algorithmes est optimisée, ce qui a pour conséquence directe de pouvoir abaisser la limite inférieure de la cadence d'échantillonnage utile. Il s'ensuit que le débit d'informations augmente et que la mesure de la dérivée gagne en précision. En d'autres termes,

**0 142 415**

pour un même intervalle de temps, la moyenne va porter sur un nombre plus grand de termes et l'erreur a contrario diminue. La dérivée de poids moyennée (filtrée) obtenue à partir de la pile circulaire est, comme on l'a vu plus haut, comparée par le calculateur à la référence de dérivées de poids. L'écart est utilisé conjointement avec les données géométriques pour contrôler les moyens de chauffage et les moyens de commande rotation-translation de la tête porte-broche.

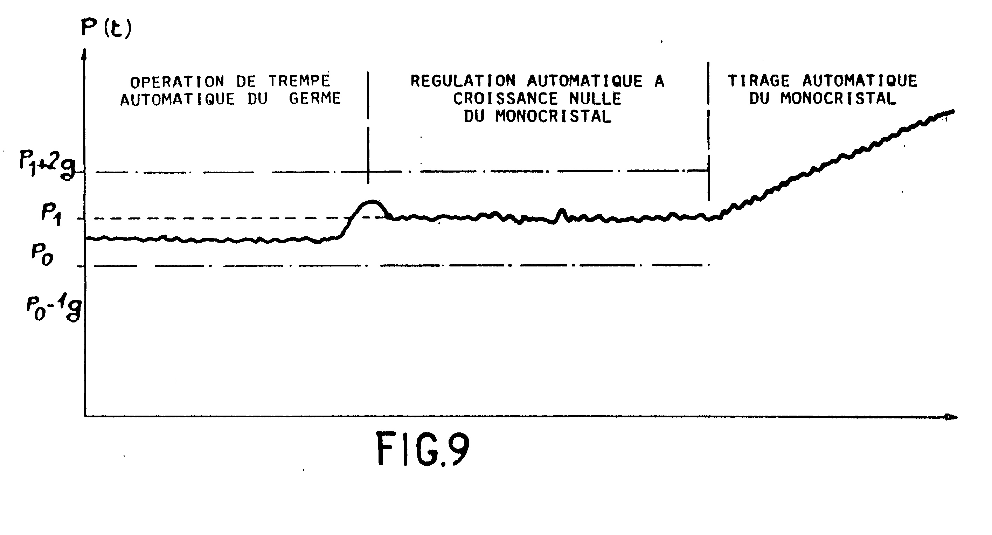

La figure 9 va maintenant permettre de mieux comprendre le procédé de l'invention. Cette figure est un diagramme représentant les variations de poids P(t), en fonction du temps t. Sur ce diagramme, on voit apparaître les opérations essentielles successives du procédé de l'invention.

Selon ce procédé, la machine est tout d'abord commandée pour effectuer une opération de trempe automatique du germe dans le bain de produit fondu, puis, cette trempe étant effectuée dans des conditions que l'on décrira plus loin en détail, la température des moyens de chauffage est régulée automatiquement pour une croissance nulle du monocristal (rotation de la broche, mais pas de translation de celle-ci). Enfin, cette régulation automatique étant effectuée, le procédé permet de contrôler le tirage automatique du monocristal, à partir des principes et calculs mentionnés plus haut.

L'opération de trempe automatique du germe consiste à approcher rapidement puis plus lentement la broche portant le germe, de la surface des produits en fusion ; durant cette opération le calculateur relié au capteur vérifie si le poids $P_0$ de la broche munie du germe reste constant. Lorsque le germe touche la surface des produits en fusion, le poids de la broche et du germe subissent une augmentation brusque représentée par une singularité telle qu'une impulsion A sur la figure. En fait, après cette augmentation brusque de poids, due aux forces de viscosité s'exerçant sur le germe, le poids de la broche et du germe retombe légèrement pour atteindre une valeur $P_1$ supérieure à la valeur $P_0$.

On suppose bien entendu que le bain de produits en fusion a été porté par les moyens de chauffage (de type haute fréquence) à la température de fusion. Pour un grenat de gallium et de gadolinium par exemple, cette température est de 1750 °C. L'opération qui permet d'amener le bain à la température de fusion a une durée de 12 heures environ. Cette durée peut être réglée directement par l'opérateur ; il en est de même de la température de fusion.

Dans l'opération de trempe automatique du germe, il peut être prévu d'approcher rapidement le germe de la surface du bain, par une descente de la broche et du germe de 1 cm toutes les minutes, puis, à partir d'un certain niveau de ce germe au-dessus de la surface du bain, de continuer cette approche selon une avance de 0,75 mm toutes les 5 secondes par exemple. Entre chaque pas de translation de la broche, une mesure de poids est effectuée et le résultat obtenu est toujours comparé au résultat du poids d'origine. Ceci permet de détecter tout incident dans la phase d'approche du germe. Si après une course prédéterminée, le contact entre le germe et la surface du bain n'est pas détecté, un appel à l'opérateur peut être déclenché automatiquement.

Si la singularité ou impulsion A dépasse un seuil prédéterminé, qui peut être par exemple fixé par $P_1 + 2g$, le signal de poids fourni par le capteur présente alors une amplitude supérieure à celle due aux simples forces de viscosité ; on en déduit qu'il y a un incident (température du bain trop faible, par exemple) et que la broche doit être remontée pour recommencer la séquence de trempe du germe.

Lorsque la trempe automatique a été correctement effectuée et que le poids indiqué par le capteur reste dans les limites tolérées, le procédé de l'invention consiste alors à commander, par l'intermédiaire du calculateur, la régulation automatique de la puissance des moyens de chauffage, pour stabiliser les conditions de départ de la cristallisation. On atteint ainsi à l'interface solide-liquide, un point d'équilibre à croissance nulle. Cette opération est réalisée grâce à un algorithme de régulation proportionnelle et intégrale (dont on a défini le principe plus haut), la référence de poids étant ici une dérivée de poids nulle. Pendant cette opération de régulation automatique, le calculateur enregistre les fluctuations d'amplitude du signal poids fourni par le capteur et après une période prédéterminée (une demi-heure par exemple), le procédé de l'invention consiste alors à commander le tirage automatique du monocristal, à condition que pendant la régulation automatique à croissance nulle, les écarts de dérivée de poids soient restés dans des limites admissibles qui sont ici, par exemples définies par $P_1 \pm 1g$.

Il est bien évident, comme on le verra plus loin, qu'à chaque instant, l'opérateur peut reprendre en main le processus, pour écourter l'opération de régulation automatique, ou pour modifier les conditions initiales ou en cas d'incident par exemple.

Des configurations anormales peuvent apparaître quand les conditions thermiques de départ sont mal fixées et que le calculateur ne peut arriver à les corriger automatiquement. C'est le cas par exemple lorsque la température du bain en fusion est trop basse qu'une croissance anarchique du monocristal est détectée. Il en est de même lorsque la température du bain en fusion est trop élevée et que le germe, au moment de la trempe, perd un poids trop important. Le calculateur peut alors réagir pour commander la baisse de la puissance fournie par les moyens de chauffage. Dans ce cas, le germe est ramené en position initiale de trempe automatique et la séquence de trempe est reprise.

L'opération suivante concerne le tirage (ou croissance) automatique du monocristal. Dans cette opération, on utilise les résultats concernant les dérivées du poids calculées plus haut. Les fluctuations de vitesse de croissance du monocristal, après filtrage numérique des dérivées de poids, sont comparées à la référence. Les écarts pondérés par les actions proportionnelles et intégrales (actions écrêtable), sont envoyées sur la sortie analogique du calculateur pour contrôler la puissance des moyens de chauffage. Pendant le tirage, les constantes de régulation et la vitesse de rotation du cristal suivent un algorithme

**0 142 415**

précis défini notamment par les paramètres introduits à l'initialisation dans la mémoire du calculateur. Pour conserver une vitesse de cristallisation constante et une position bien définie de l'interface solide-liquide, les vitesses de translation de la broche et du creuset sont calculées à chaque instant en fonction de la référence de dérivées de poids. Il est à noter que l'opérateur peut à chaque instant, ajuster manuellement les constantes de régulation ; il peut de même intervenir à tout instant, en cas d'urgence, pour arrêter la croissance.

Enfin, la dernière opération qui n'est pas représentée sur le diagramme de la figure 9, consiste à contrôler le refroidissement des moyens de chauffage ; le calculateur commande automatiquement la séparation du cristal et du bain, puis l'arrêt lent de la rotation de la broche, puis la baisse de la puissance de chauffage (15 heures environ).

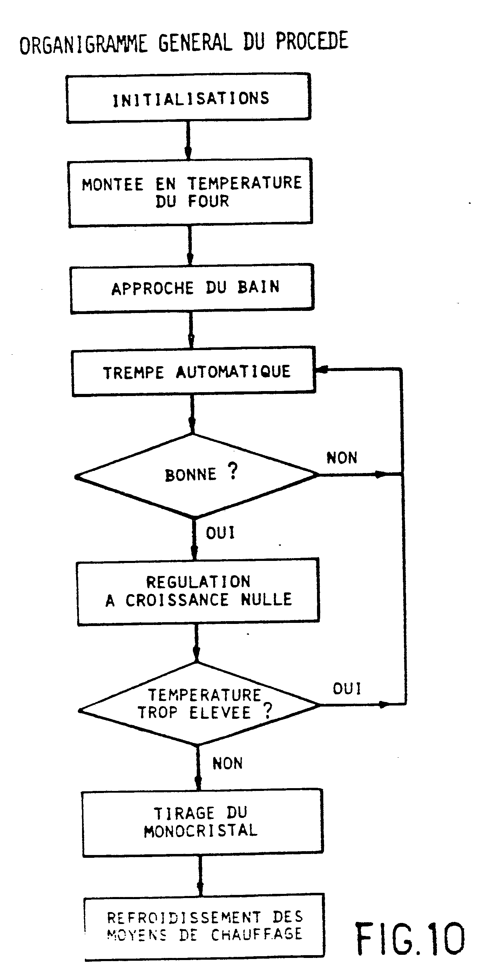

La figure 10 est un organigramme général du procédé de l'invention. La mise en œuvre du procédé débute par une opération d'initialisation au cours de laquelle les paramètres mentionnés plus haut sont introduits dans la mémoire du calculateur. Ce sont notamment les paramètres concernant la forme du monocristal à obtenir, les vitesses de translation et de rotation, la température des moyens de chauffage, etc.

La seconde opération consiste à fixer la température des moyens de chauffage, en fonction des produits contenus dans le creuset.

L'opération suivante concerne l'approche automatique du bain de produits en fusion, cette approche étant d'abord une approche rapide, puis une approche beaucoup plus lente, comme indiqué plus haut.

L'opération suivante concerne la trempe automatique de l'extrémité du germe dans le bain de produits en fusion ; cette trempe automatique sera décrite plus loin, à l'aide d'un organigramme plus détaillé.

La trempe automatique est vérifiée par un test pour reconnaître, en fonction des mesures de poids fournies par le capteur, si cette trempe est bonne ou non. Si la trempe automatique se révèle défectueuse (réponse NON à la question « trempe bonne »), la broche de tirage est remontée et une nouvelle trempe doit être effectuée. Si au contraire, la trempe automatique n'est pas défectueuse (réponse OUI à la question précédente), l'opération suivante consiste à effectuer une régulation de la température des moyens de chauffage, à croissance nulle du monocristal. Cette opération de régulation à croissance nulle sera décrite plus loin à l'aide d'un organigramme plus détaillé. (Dans la croissance nulle, la broche subit un mouvement de rotation ; aucun mouvement de translation ne lui est appliqué. Cette opération permet d'assurer la bonne cristallisation des produits à l'extrémité du germe).

L'opération suivante consiste à contrôler si la température des moyens de chauffage est située entre des limites haute et basse acceptables. Si cette température est trop élevée, le germe situé à l'extrémité de la broche fond à la surface du bain de produits fondus et le tirage est impossible. Il est alors nécessaire de remonter la broche et le germe pour effectuer une nouvelle trempe automatique de celui-ci, après baisse de la température. Si au contraire, la température est trop faible, il est nécessaire d'agir sur les moyens de chauffage pour augmenter cette température. Entre ces deux limites, le tirage du monocristal peut commencer.

Le tirage du monocristal sera décrit plus loin à l'aide d'un organigramme plus détaillé. Enfin, la dernière opération consiste à refroidir progressivement les moyens de chauffage, à la fin du tirage, pour extraire le monocristal.

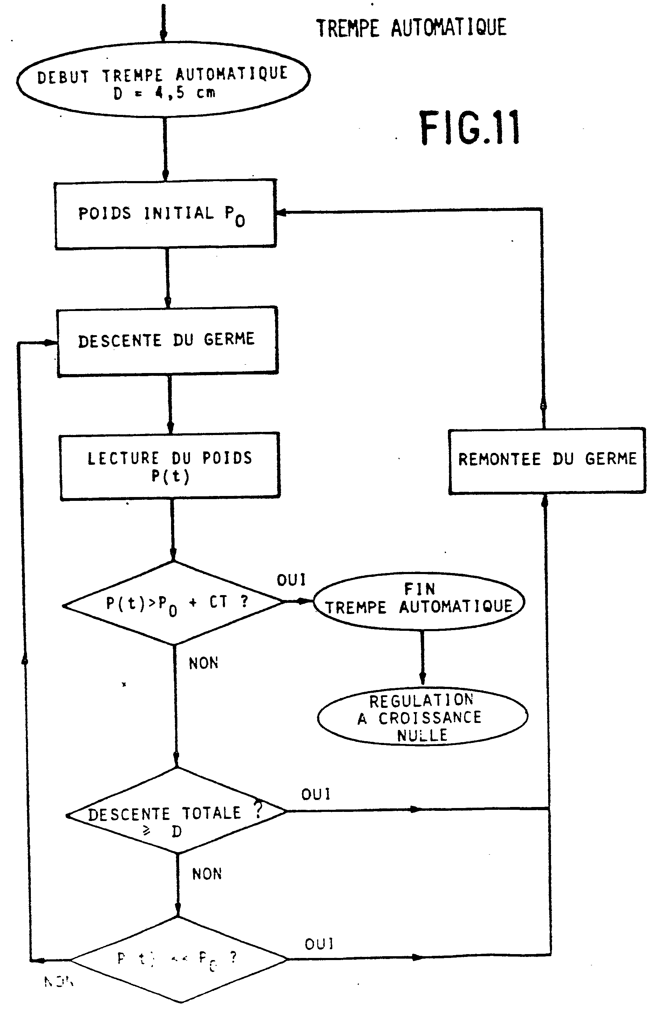

La figure 11 est un organigramme qui permet de mieux comprendre l'opération de trempe automatique du germe. Cette opération débute, lorsque le germe situé à l'extrémité de la broche de tirage est placé par exemple à une distance $D = 4,5$ cm de la surface des produits en fusion dans le creuset.

Le poids $P_0$ de la broche de tirage munie du germe, est mesuré par le capteur.

Ensuite, la broche et le germe effectuent une approche comme indiqué plus haut, de la surface du bain en fusion. Au cours de cette approche, le poids $P(t)$ de la broche et du germe est constamment mesuré. En principe, au cours de cette descente vers la surface du bain de produits en fusion, le poids $P(t)$ doit être sensiblement voisin du poids $P_0$ initial. Lorsque le germe entre en contact avec la surface du bain, comme on l'a indiqué plus haut, les forces de tension superficielles qu'exercent les produits en fusion sur le germe provoquent une augmentation de poids mesurée par le capteur. Si le poids $P(t)$ mesuré par le capteur est supérieur au poids initial $P_0$ augmenté d'un poids CT définissant un critère de trempe effective, c'est que la trempe automatique est réussie (réponse OUI à la question $P(t) > P_0 + CT$). En fait, cette augmentation de poids au moment du contact du germe est représentée par l'impulsion A sur la figure 9. C'est alors la fin de la trempe automatique du germe et le début de la régulation à croissance nulle ; cette régulation sera décrite plus loin par un organigramme détaillé.

Si au contraire, la réponse à la question $P(t) > P_0 + CT$ est NON, la phase d'approche du germe avec la surface du bain de produits en fusion continue et on vérifie en permanence si la descente totale du germe n'est pas supérieure ou égale à la distance $D + 1$ cm qui séparait ce germe et la surface du bain au début du processus de trempe automatique. Si la descente totale du germe est supérieure à la distance $D + 1$ cm, c'est que, par exemple, le germe se fond au contact du bain et qu'il faut le remonter pour éviter de fondre la broche. Le germe peut être remonté de 2 cm par exemple et le processus de trempe automatique est repris de la manière décrite précédemment, avec vérification initiale du poids $P_0$ du germe et de la broche.

Si au cours des tentatives successives de trempe automatique du germe, le poids $P(t)$ subit une perte

14

importante par rapport au poids initial $P_0$ (réponse OUI à la question $P(t) < < P_0$), c'est que le germe a perdu trop de poids et qu'il est urgent de le remonter. Si au contraire, la réponse à la question $P(t) < < P_0$ est NON, c'est que la descente du germe peut continuer normalement.

Il est à remarquer qu'au moment du contact du germe avec la surface du bain de produits en fusion, les forces de viscosité introduisent un accroissement transitoire de la valeur du poids de la broche et du germe. Le signal émis par le capteur de poids est faible et très fugitif. L'accroissement de poids $P(t) - P_0$ doit être supérieur au critère de trempe CT, choisi par l'opérateur en fonction des produits en fusion et du diamètre du germe. Par mesure de sécurité, la descente fractionnée du germe est limitée à 5,5 cm, afin d'éviter que la canne supportant le germe ne vienne plonger dans le bain et se fondre dans celui-ci.

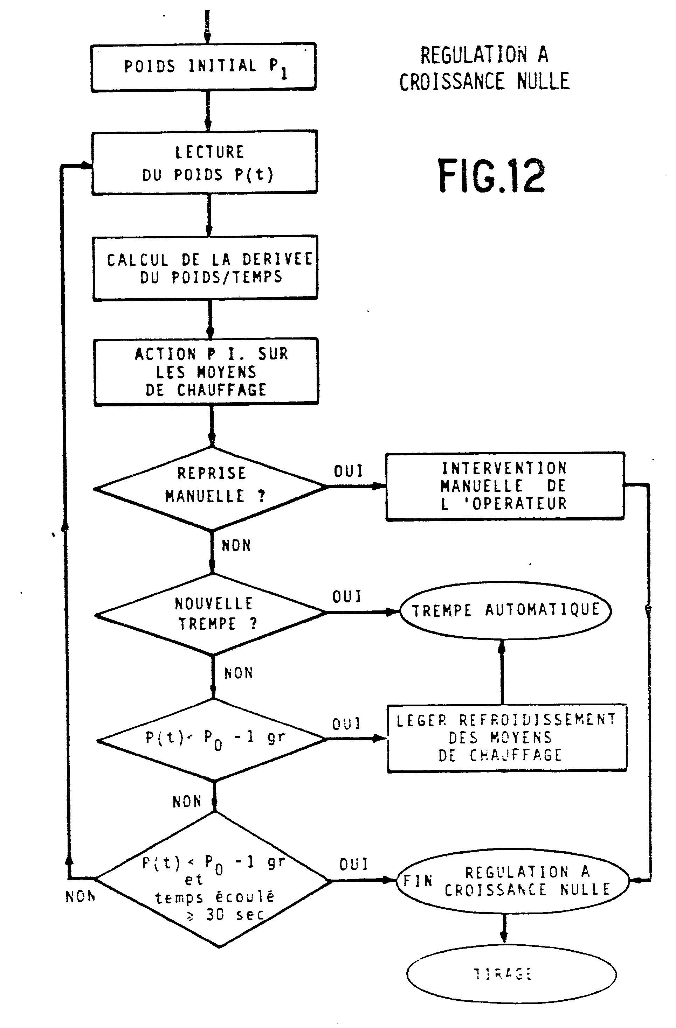

La figure 12 est un organigramme qui décrit l'opération de régulation de la température des moyens de chauffage, à croissance nulle du monocristal. Cette opération débute au moment où le poids initial indiqué par le capteur est égal à $P_1$ (voir figure 9), c'est-à-dire à la fin de l'impulsion A provoquée par l'accroissement du poids de la broche et du germe lorsque le contact du germe avec les produits fondus est effectif.

Au cours de cette régulation à croissance nulle, il est procédé à une mesure permanente du poids de la broche et du germe à la période d'échantillonnage PE = $\Delta t$ mentionnée plus haut.

Le calculateur fournit alors les variations des différences des dérivées de poids par rapport à la référence, comme on l'a indiqué plus haut ; le calculateur effectue ensuite une action proportionnelle et intégrale sur la fonction représentative de ces variations. C'est la fonction résultant de cette action qui est utilisée pour contrôler la tension de régulation des moyens de chauffage. Cette régulation permet en fait de maintenir le poids $P_1$ sensiblement constant pendant la durée de la régulation. Au cours de l'action proportionnelle et intégrale, l'opérateur peut effectuer une commande manuelle (réponse OUI à la question « reprise manuelle »), par exemple lorsqu'il juge que la régulation automatique de la température du four est suffisante et qu'il peut déclencher plus rapidement le tirage (ou croissance) du monocristal.

Au contraire, si l'opérateur ne décide pas de reprise manuelle (réponse NON à la question précédente) et qu'il s'avère que les moyens de chauffage sont à une température trop élevée, le calculateur peut commander une nouvelle trempe automatique (réponse OUI à la question « nouvelle trempe » ?).

Le calculateur vérifie aussi en permanence que le poids $P(t)$ de la broche et du germe en contact avec le bain n'est pas inférieur à une limite basse prédéterminée qui, dans l'exemple décrit est égal à $P_0 - 1g$ (voir figure 9). Si la réponse à la question $P(t) < P_0 - 1g$ ?, est OUI, c'est que les moyens de chauffage présentent une température trop élevée et qu'il est nécessaire que le calculateur commande un léger refroidissement des moyens de chauffage.

Au contraire, si la réponse à la question précédente est NON, le calculateur vérifie si le poids $P(t)$ indiqué par le capteur est inférieur ou égal à une autre limite haute prédéterminée qui, dans l'exemple considéré, est égale à $P_1 + 2g$ (voir figure 9).

Si la réponse à la question $P(t) \leq P_1 + 2g$ et temps écoulé $\geq 30'$ est OUI, c'est que la fin du processus de régulation à croissance nulle est atteinte et que le tirage du monocristal peut commencer. Au contraire, si la réponse à la question précédente est NON, c'est par exemple que les moyens de chauffage sont trop froids et qu'il est nécessaire d'effectuer un nouveau contrôle de la régulation de température des moyens de chauffage.

En fait, lorsque $P(t) < P_0 - 1g$, la température trop élevée des moyens de chauffage a fait fondre le germe. Le poids lu par le capteur diminue. Quand $P(t) \geq P_1 + 2g$, la température trop basse des moyens de chauffage a fait cristalliser les produits fondus, autour du germe. Si l'apport de produits n'est pas trop important, la régulation automatique des moyens de chauffage, effectuée par le calculateur, peut ramener le processus dans l'état voulu, sinon une reprise manuelle s'impose.

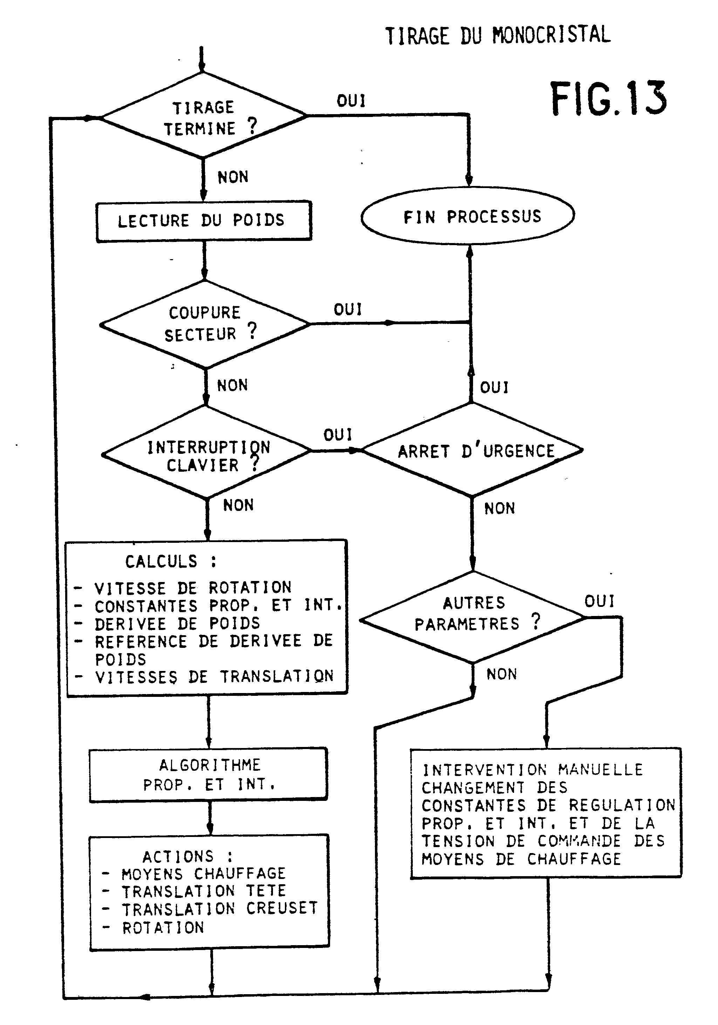

La figure 13 représente schématiquement l'opération de tirage (ou croissance) du monocristal, intervenant après l'opération de régulation à croissance nulle.

Si le tirage est terminé (réponse OUI à la question « tirage terminé » ?), c'est la fin du processus de croissance.

Au contraire, si la réponse à cette question est NON, le calculateur reçoit des indications de mesures de poids et fournit les signaux de commande nécessaires au contrôle de la vitesse de rotation de la broche, calcule les valeurs des dérivées de poids, élabore la référence de dérivées de poids. Le calculateur traite ensuite l'algorithme proportionnel et intégral de manière à commander la régulation automatique de la température des moyens de chauffage, pendant la croissance. Le traitement de cet algorithme permet de plus, au calculateur de commander la translation de la broche et du creuset, ainsi que la rotation de cette broche.

Si en cours de processus de tirage, une coupure du secteur électrique alimentant la machine intervient (réponse OUI à la question coupure du secteur ?) le calculateur commande automatiquement la fin du processus de tirage.

Si au contraire la réponse à la question précédente est NON, le processus de tirage peut continuer comme décrit plus haut ; l'opérateur peut éventuellement effectuer une opération d'interruption grâce au clavier d'introduction de données de l'ordinateur (réponse OUI à la question « interruption clavier » ?) ; cette interruption à partir du clavier du calculateur peut, soit provoquer un arrêt d'urgence de la machine pour interrompre le processus de tirage en cas d'incident par exemple, soit permettre l'introduction d'autres paramètres relatifs au tirage du monocristal, dans la mémoire du calculateur.

Si la réponse à la question « autres paramètres ? » est OUI, l'opérateur intervient manuellement par exemple pour changer les constantes de régulation proportionnelles et intégrales de façon à modifier la tension de contrôle des moyens de chauffage. En l'absence d'interruption clavier, le processus de tirage continue bien entendu de manière automatique, comme décrit plus haut.

Le procédé qui vient d'être décrit permet de maîtriser la trempe et le tirage automatique en améliorant les rendements de production de manière très significative. Les machines commandées selon le procédé de l'invention présentent un fonctionnement reproductible, avec le minimum de surveillance. Ces machines peuvent être par exemple utilisées durant des périodes de tarification réduites de la consommation électrique et ceci est très important, puisque ces machines consomment une grande quantité d'énergie.

Le bon déroulement de la croissance est contrôlable a posteriori en comparant le cristal obtenu avec le gabarit géométrique ayant servi à introduire les données dans le calculateur.

**Revendications**

1. Procédé de commande d'une machine de tirage de monocristaux, cette machine comprenant un creuset (14) contenant un bain d'un produit fondu (15) et stabilisé à une température supérieure au point de fusion du produit, par des moyens de chauffage, de régulation et de mesure de température (9), le tirage étant effectué à l'aide d'un germe monocristallin du produit placé à l'extrémité inférieure d'une broche de tirage (12) d'axe vertical, la machine comprenant aussi un bâti parallèlement à l'axe propre de la broche de tirage (12), des moyens (18) pour commander la translation du chariot selon au moins deux vitesses différentes, des moyens (5) pour commander une translation du creuset parallèlement à l'axe de la broche, le chariot (16) supportant la broche de tirage par l'intermédiaire de moyens (54) pour commander la rotation de celle-ci autour de son axe propre, la broche de tirage (12) comprenant un capteur de poids fournissant des signaux représentatifs du poids de la broche et du germe, avant le tirage, et de l'évolution de ce poids au cours du tirage, ces signaux étant appliqués à des circuits (72, 78) de traitement électronique reliés à un calculateur (84) de contrôle de la régulation des moyens de chauffage et de contrôles des moyens (18, 5, 54) de commande de translation du chariot, de translation du creuset et de rotation de la broche, le procédé consistant aussi à enregistrer dans une mémoire (85) du calculateur des paramètres prédéterminés relatifs à la géométrie du monocristal à obtenir et à la croissance de celui-ci, des signaux représentatifs du poids fournis par le capteur de poids et traités par des circuits de traitement, et à enregister dans cette mémoire un programme pour que ce calculateur (84) commande une mise à la température des moyens de chauffage (9), après contact du germe avec la surface du bain, une régulation automatique de la température des moyens de chauffage pour une croissance nulle du cristal, le tirage automatique du cristal et le refroidissement des moyens de chauffage à la fin du tirage, caractérisé en ce que le programme enregistré dans la mémoire est en outre conçu pour commander une approche automatique rapide du bain par la broche munie du germe, jusqu'à une distance prédéterminée de la surface de ce bain, une approche plus lente du bain jusqu'au contact du germe avec la surface du bain, les approches lente et rapide et le tirage étant effectués par l'action du calculateur sur les moyens de commande de la translation du chariot et du creuset et de rotation de la broche, à partir des mesures du poids du germe et du cristal fournies par le capteur de poids, la régulation automatique des moyens de chaufage pour une croissance nulle du monocristal intervenant dès le contact du germe avec la surface du bain et consistant à déterminer, à partir des signaux fournis par le capteur, les dérivées de poids par rapport au temps, pour une période d'échantillonnage prédéterminée, puis à appliquer à la fonction représentative de l'écart de ces dérivées de poids par rapport à une référence nulle de dérivée de poids, une action proportionnelle et intégrale avec un écrêtage différent, selon que ces écarts sont appliqués au terme proportionnel ou au terme intégral, la fonction ainsi traitée étant représentative d'une tension de consigne des moyens de chauffage pour une croissance nulle de monocristal, les amplitudes des signaux fournis par le capteur étant situées entre les deux limites prédéterminées pendant cette opération de régulation.

2. Procédé selon la revendication 1, caractérisé en ce que la détection du contact du germe avec la surface du bain consiste à repérer une singularité dans les signaux représenttifs du poids de la broche et du germe au moment du contact du germe vers la surface des produits en fusion, les amplitudes de ces signaux et de cette singularité étant situées entre deux limites haute et basse prédéterminées.

3. Procédé selon la revendicaiton 2, caractérisé en ce que le tirage consiste, par translation de la broche et du creuset, à maintenir une variation contrôlée des dérivées de poids au cours du tirage, par comparaison de ces dérivées avec une dérivée de poids de référence, la régulation de la température des moyens de chauffage étant obtenue à partir de la fonction représentative de l'écart de ces dérivées de poids, traitée par une action proportionnelle et intégrale avec un écrêtage différent selon que ces écarts sont appliqués au terme proportionnel ou au terme intégral, la fonction ainsi traitée étant représentative d'une tension de régulation des moyens de chauffage pour une croissance contrôlée du monocristal.

4. Procédé selon la revendication 2, caractérisé en ce qu'il consiste à abaisser la température des moyens de chauffage lorsque les amplitudes des signaux fournis par le capteur sont inférieures à la limite la plus basse, et à augmenter cette température lorsque les amplitudes des signaux fournis par le capteur sont supérieures à la limite la plus haute.

5. Procédé selon l'une quelconque des revendications 3 et 4, caractérisé en ce qu'il consiste en outre à interrompre les commandes du calculateur en cas d'incident ou pour introduire dans la mémoire des nouveaux paramètres de régulation ou de tirage.

6. Procédé selon l'une quelconque des revendications 1 à 3, caractérisé en ce qu'il consiste à utiliser comme signal pertinent de régulation la dérivée de poids du cristal dont on cherche à contrôler la croissance.

7. Procédé selon la revendication 6, caractérisé en ce qu'il consiste à filtrer numériquement le rapport signal/bruit de la dérivée de poids.

8. Procédé selon la revendication 7, caractérisé en ce que la dérivée de poids est prise sur un nombre M entier de périodes d'échantillonnage, le filtrage consistant à effectuer une moyenne de valeurs glissantes de dérivées de poids de taille N, N étant un entier.

9. Procédé selon l'une quelconque des revendications 1 à 3, caractérisé en ce que la référence de dérivée de poids est calculée à partir des données géométriques liées à la forme physique du cristal à obtenir.

## Claims

1. Process for the control of a monocrystal pulling machine comprising a crucible (14) containing a bath of a molten product (15) and stabilized at a temperature and measuring means (9), pulling being carried out with the aid of a monocrystalline nucleus of the product placed at the lower end of a vertically axed pulling pin, the machine also comprising a fixed frame (10), a carriage (16) which moves relative to the frame parallel to the axis of the pulling pin (12), means (18) for controlling the translation of the carriage in accordance with a least two different speeds, means (5) for controlling a translation of the crucible parallel to the pin axis, the carriage (16) supporting the pulling pin via means (54) for controlling the rotation thereof about its own axis, the pulling pin (12) incorporating a weight transducer supplying signals representing the weight of the pin and the nucleus prior to pulling and the evolution of said weight during pulling, said signals being applied to electronic processing circuits (72, 78) connected to a computer (84) for checking the regulation of the heating means and checking the means (18, 5, 54) for controlling the translation of the carriage, the tanslation of the crucible and the rotation of the pin, the process also comprising recording in a memory (85) of the computer predetermined parameters relative to the geometry of the monocrystal to be obtained and to the growth thereof, signals representative of the weight supplied by the weight transducer and processed by processing circuits and recording in said memory a program, so that said computer (84) controls the raising of the product and then, after contact between the nucleus and the surface of the bath, an automatic regulation of the temperature of the heating means for a zero crystal growth, the automatic pulling of the crystal and the cooling of the heating means at the end of pulling, characterized in that the program recorded in the memory is also intended to control an automatic fast approach of the bath by the pin provided with the nucleus up to a predetermined distance from the bath surface, a slower approach of the bath until the nucleus is in contact with the bath surface, the slow and fast approaches and pulling being effected by the action of the computer on the means for controlling the translation of the carriage and the crucible, as well as the rotation of the pin, on the basis of measurements of the weight of the nucleus and of the crystal supplied by the weight transducer, the automatic regulation of the heating means for a zero monocrystal growth intervening as soon as the nucleus is in contact with the bath surface and consisting of determining, on the basis of signals supplied by the transducer, the weight derivatives with respect to time for a predetermined sampling period, then applying to the representative function of the variation of these weight derivatives with respect to a zero weight derivative reference, a proportional and integral action with a different clipping as a function of whether these variations are applied to the proportional term or to the integral term, the thus processed function representing a reference voltage of the heating means for a zero growth of the monocrystal, the amplitudes of the signal supplied by the transducer being between the two limits predetermined during said regulating operation.

2. Process according to claim 1, characterized in that the detection of the contact between the nucleus and the surface of the bath consists of noting a singularity in the signals representing the weight of the pin and the nucleus at the time of contact between the nucleus and the surface of the molten products, the amplitudes of said signals and of said singularity being between two predetermined upper and lower limits.

3. Process according to claim 2, characterized in that pulling comprises, by translation of the pin and the crucible, maintaining a controlled variation of the weight derivatives during pulling by comparing these derivatives with a reference weight derivative, the regulation of the temperature of the heating means being obtained on the basis of the function representative of the variation of these weight derivatives, processed by a proportional and integral action with a different clipping as a function of whether these variations are applied to the proportional term or to the integral term, the thus processed function representing a regulating voltage of the heating means for a controlled growth of the monocrystal.

4. Process according to claim 2, characterized in that it comprises lowering the temperature of the heating means when the amplitudes of the signals supplied by the transducer are below the lowest limit and increasing said temperature when the amplitudes of the signals supplied by the transducer are above the highest limit.

5. Process according to either of the claims 3 and 4, characterized in that it also comprises interrupting the controls of the computer in the case of an incident or for introducing new regulating or pulling parameters into the memory.

6. Process according to any one of the claims 1 to 3, characterized in that it comprises using as the relevant regulating signal, the weight derivative of the crystal, whose growth it is wished to control.

7. Process according to claim 6, characterized in that it comprises numerically filtering the signal-to-noise ratio of the weight derivative.

8. Process according to claim 7, characterized in that the weight derivative is taken on an integral number M of sampling periods, filtering consisting of effecting a means of the sliding values of the weight derivatives of size N, N being an integer.

9. Process according to any one of the claims 1 to 3, characterized in that the weight derivative reference is calculated on the basis of geometrical data linked with the physical form of the crystal to the obtained.

**Patentansprüche**

1. Steuerverfahren einer Vorrichtung zum Kristallziehen, wobei diese Vorrichtung umfaßt einen Schmelztiegel (14), der ein Schmelzbad eines Produkts (15) enthält, das durch Heizungs-, Regel- und Temperaturmeßmitel (9) auf einer Temperatur oberhalb des Schmelzpunkts des Produkts stabilisiert wird, wobei das Ziehen mit Hilfe eines monokristallinen Keims des Produkts durchgeführt wird, welcher am unteren Ende eines Ziehdorns (12) mit vertikaler Achse angeordnet ist, und die Vorrichtung ferner auch umfaßt ein festes Grundgestell (10), einen in bezug auf das Grundgestell parallel zu der eigenen Achse des Ziehdorns (12) bewegbaren Schlitten (16), Mittel (18), um die Verschiebung des Schlittens mit wenigstens zwei unterschiedlichen Geschwindigkeiten zu steuern, Mittel (5), um eine Verschiebung des Schmelztiegels parallel zu der Achse des Dorns zu steuern, wobei der Schlitten (16) den Ziehdorn mittels einer Einrichtung (54) zur Steuerung dessen Drehung um seine eigene Achse hält, der Ziehdorn (12) einen Gewichtsfühler aufweist, der vor dem Ziehen das Gewicht des Dorns und des Fühlers während des Ziehens die Entwicklung dieses Gewichts angebende Signale liefert, diese Signale elektronischen Verarbeitungskreisen (72, 78) aufgeschaltet sind, die mit einem Rechner (84) zur Steuerung der Regelung der Heizungsmittel und der Mittel (18, 5, 54) zur Steuerung der Verschiebung des Schlittens, der Verschiebung des Schmelztiegels und der Drehung des Dorns verbunden sind, das Verfahren auch darin besteht, in einem Speicher (85) des Rechners vorbestimmte, die Geometrie des zu erhaltenden Einkristalls und dessen Wachsen betreffende Parameter, für das Gewicht repräsentative Signale, die von dem Gewichtsfühler abgegeben und von den Verarbeitungskreisen verarbeitet sind, und in diesem Speicher ein Programm zu speichern, damit dieser Rechner (84) die Heizungsmittel (9) auf die Temperatur steuert, um das Produkt zu schmelzen, dann nach der Berührung des Keimes mit der Badoberfläche eine automatische Regelung der Temperatur für ein Nullwachstum des Kristalls, das automatische Ziehen des Kristalls und das Abkühlen der Heizmittel am Ende des Ziehens steuert, dadurch gekennzeichnet, daß das in dem Speicher gespeicherte Programm ausgelegt ist, zu steuern eine automatische, schnelle Annäherung des Bades durch den mit Keim versehenen Dorn bis zu einem vorbestimmten Abstand von der Oberfläche dieses Bades, eine Langsamere Annäherung des Bades bis zur Berührung des Keimes mit der Oberfläche des Bades, wobei die schnelle und Langsame Annäherung und das Ziehen durch die Wirkung des Rechners auf die Steuermittel für die Verschiebung des Schlittens und des Schmelztiegels und die Drehung des Dorns ausgehend von den von dem Gewichtsfühler gelieferten Gewichtsmessungen des Keimes und des Kristalls durchgeführt wird, die automatische Regelung der Heizungsmittel für ein Nullwachstum des Einkristalls von der Berührung des Keimes mit der Oberfläche des Bades an eingreift und darin besteht, ausgehend von den von dem Fühler gelieferen Signalen die Ableitungen des Gewichts nach der Zeit für eine vorbestimmte Maßperiode zu bestimmen, dann auf die Funktion, die für die Abweichung dieser Ableitungen des Gewichts von einem Nullbezug der Gewichtsableitung repräsentativ ist, eine proportionale und integrale Wirkung mit unterschiedlicher Begrenzung je nachdem anzuwenden, ob diese Abweichungen auf einen Proportionalterm oder einen Integralterm angewendet werden, wobei die derart behandelte Funktion für eine Sollspannung der Heizmittel für ein Nullwachstum des Einkristalls repräsentativ ist und die von dem Fühler gelieferten Signalamplituden während dieses Regelvorgangs zwischen den zwei vorbestimmten Grenzen liegen.

2. Verfahren nach Anspruch 1, dadurch gekennzeichnet, daß die Erfassung der Berührung des Keimes mit der Oberfläche des Bades darin besteht, eine Singularität in den Signalen, die für das Gewicht des Dorns und des Keims repräsentativ sind, zum Zeitpunkt der Berührung des Keimes mit der Oberfläche der Schmelzprodukte zu erfassen, wobei sich die Amplituden dieser Signale und dieser Singularität zwischen einer vorbestimmten oberen und unteren Grenze befinden.

3. Verfahren nach Anspruch 2, dadurch gekennzeichnet, daß das Ziehen darin besteht, durch Verschieben des Dorns und des Schmelztiegels eine gesteuerte Änderung der Ableitungen des Gewichts während des Ziehens durch Vergleich dieser Ableitungen mit einer Ableitung eines Bezugsgewichts aufrecht zu erhalten, wobei die Regelung der Temperatur der Heizungsmittel ausgehend von der für die Abweichung dieser Ableitungen des Gewichts repräsentativen Funktion erhalten wird, die mit einer proportionalen und integralen Wirkung mit einer unterschiedlichen Begrenzung je nachdem mit einer unterschiedlichen Begrenzung je nachdem behandelt wird, ob diese Abweichungen auf einen proportionalen Term oder einen Integralterm angewandt werden, wobei die derart behandelte Funktion für eine Regelspannung der Heizungsmittel für ein gesteuertes Wachsen des Einkritalls repräsentativ ist.

4. Verfahren nach Anspruch 2, dadurch gekennzeichnet, daß es darin besteht, die Temperatur der Heizungsmittel zu senken, wenn die von dem Fühler gelieferten Signalamplituden kleiner als die unterste Grenze sind, und diese Temperatur zu erhöhen, wenn die von dem Fühler gelieferten Signalamplituden höher als die oberste Grenze sind.

5. Verfahren nach irgendeinem der Ansprüche 3 oder 4, dadurch gekennzeichnet, daß es ferner darin besteht, die Befehle von dem Rechner im Falle einer Störung zu unterbrechen oder in den Speicher neue Parameter zum Regeln oder Ziehen einzugeben.

6. Verfahren nach irgendeinem der Ansprüche 1 bis 3, dadurch gekennzeichnet, daß es darin besteht, als Dauerregelsignal die Ableitung des Gewichts des Kristalls zu verwenden, dessen Wachsen man zu steuern versucht.

7. Verfahren nach Anspruch 6, dadurch gekennzeichnet, daß es darin besteht, numerisch das Signal/Störverhältnis der Ableitung des Gewichts zu filtern.

8. Verfahren nach Anspruch 7, dadurch gekennzeichnet, daß die Ableitung des Gewichts bei einer ganzen Zahl M von Maßperioden erfolgt, wobei das Filtern darin besteht, ein Mittel von gleitenden Werten der Gewichtsableitungen der Größe N zu bilden, mit N einer ganzen Zahl.

9. Verfahren nach irgendeinem der Ansprüche 1 bis 3, dadurch gekennzeichnet, daß die Bezugsableitung des Gewichts ausgehend von geometrischen Werten berechnet wird, die mit der physikalischen Form des zu erhaltenden Kristalls verknüpft sind.

FIG.1

FIG.2

# FIG.3

**FIG.4**

$\phi 1$

$H_1$

$R1$

$\theta$

$H_2$

$R2$

$HT$

$\phi 2$

**FIG.5**

$d$

$ds$

$dh$

$dVs$

$N1$

$N2$

14

$D$

**FIG.6**

$Q_2(t)$

ECRÊTAGE PROPORTIONNEL ET INTÉGRAL

$\widetilde{Q}_2(t)$

$+E_1$

$\bar{Q}_2(t)$

$+Ep$

$\bar{Q}_2(t)$

$t$

$-Ep$

ECRÊTAGE PROPORTIONNEL

FIG.7

FIG.8

① A + 1 = 12

| N | 1 | 2 | 3 | 4 | 5 | 6 | 7 | 8 | 9 | 10 | 11 |
|---|---|---|---|---|---|---|---|---|---|---|---|
| M | 11 | 10 | 9 | 8 | 7 | 6 | 5 | 4 | 3 | 2 | 1 |
| $\frac{\sigma S}{\Delta P}$ | 11 | 14,14 | 15,59 | 16 | 15,65 | 14,70 | 15,65 | 16 | 15,59 | 14,14 | 11 |

② A + 1 = 24

| N | 1 | 2 | 3 | 4 | 5 | 6 | 7 | 8 | 9 | 10 | 11 | 12 |
|---|---|---|---|---|---|---|---|---|---|---|---|---|
| M | 23 | 22 | 21 | 20 | 19 | 18 | 17 | 16 | 15 | 14 | 13 | 12 |
| $\frac{\sigma S}{\Delta P}$ | 23 | 31,11 | 36,37 | 40 | 42,49 | 44,09 | 44,98 | 45,25 | 45 | 44,27 | 43,12 | 41,57 |

**FIG.9**

P(t)

OPERATION DE TREMPE AUTOMATIQUE DU GERME

REGULATION AUTOMATIQUE A CROISSANCE NULLE DU MONOCRISTAL

TIRAGE AUTOMATIQUE DU MONOCRISTAL

$P_1+2g$

$P_1$

$P_0$

$P_0-1g$

0 142 415

ORGANIGRAMME GENERAL DU PROCEDE

```
        ┌─────────────────────────┐
        │     INITIALISATIONS     │
        └────────────┬────────────┘
                     │
        ┌────────────▼────────────┐
        │  MONTEE EN TEMPERATURE  │
        │        DU FOUR          │
        └────────────┬────────────┘
                     │
        ┌────────────▼────────────┐
        │     APPROCHE DU BAIN    │
        └────────────┬────────────┘
                     │
        ┌────────────▼────────────┐◄──────────┐
        │   TREMPE AUTOMATIQUE    │           │
        └────────────┬────────────┘           │
                     │                        │
                 ╱───▼───╲        NON         │
                ╱  BONNE ? ╲──────────────────┤
                ╲         ╱                    │
                 ╲───┬───╱                     │
                     │ OUI                      │
        ┌────────────▼────────────┐            │
        │       REGULATION        │            │
        │   A CROISSANCE NULLE     │            │
        └────────────┬────────────┘            │
                     │                          │
                 ╱───▼───╲        OUI            │
                ╱TEMPERATURE╲──────────────────┘
                ╲TROP ELEVEE?╱
                 ╲───┬───╱
                     │ NON
        ┌────────────▼────────────┐
        │       TIRAGE DU         │
        │      MONOCRISTAL        │
        └────────────┬────────────┘
                     │
        ┌────────────▼────────────┐
        │ REFROIDISSEMENT DES     │        FIG.10
        │ MOYENS DE CHAUFFAGE     │
        └─────────────────────────┘
```

FIG.10

7

TREMPE AUTOMATIQUE

# FIG.11

DEBUT TREMPE AUTOMATIQUE
D = 4,5 cm

POIDS INITIAL $P_0$

DESCENTE DU GERME

LECTURE DU POIDS
P(t)

REMONTEE DU GERME

$P(t) > P_0 + CT$ ?

OUI

FIN
TREMPE AUTOMATIQUE

NON

REGULATION
A CROISSANCE
NULLE

DESCENTE TOTALE ?
$\geq$ D

OUI

NON

$P(t) < P_0$ ?

OUI

NON

POIDS INITIAL $P_1$

REGULATION A
CROISSANCE NULLE

# FIG.12

LECTURE
DU POIDS P(t)

CALCUL DE LA DERIVEE
DU POIDS/TEMPS

ACTION P I. SUR
LES MOYENS
DE CHAUFFAGE

REPRISE
MANUELLE ?

OUI → INTERVENTION
MANUELLE DE
L'OPERATEUR

NON

NOUVELLE
TREMPE ?

OUI → TREMPE AUTOMATIQUE

NON

$P(t) < P_0 - 1$ gr

OUI → LEGER REFROIDISSEMENT
DES MOYENS
DE CHAUFFAGE

NON

$P(t) < P_0 - 1$ gr
et
temps écoulé
$\geq$ 30 sec

OUI → FIN REGULATION A
CROISSANCE NULLE

NON

TIRAGE

TIRAGE DU MONOCRISTAL

# FIG.13

Flowchart:

TIRAGE TERMINE ? — OUI → FIN PROCESSUS

NON ↓

LECTURE DU POIDS

↓

COUPURE SECTEUR ? — OUI → (FIN PROCESSUS)

NON ↓

INTERRUPTION CLAVIER ? — OUI → ARRET D'URGENCE — OUI → FIN PROCESSUS

NON ↓ / ARRET D'URGENCE — NON ↓

CALCULS :
- VITESSE DE ROTATION
- CONSTANTES PROP. ET INT.
- DERIVEE DE POIDS
- REFERENCE DE DERIVEE DE POIDS
- VITESSES DE TRANSLATION

AUTRES PARAMETRES ? — OUI →

NON ↓

ALGORITHME PROP. ET INT.

↓

ACTIONS :
- MOYENS CHAUFFAGE
- TRANSLATION TETE
- TRANSLATION CREUSET
- ROTATION

INTERVENTION MANUELLE CHANGEMENT DES CONSTANTES DE REGULATION PROP. ET INT. ET DE LA TENSION DE COMMANDE DES MOYENS DE CHAUFFAGE